# EUROPEAN PATENT SPECIFICATION

(11) **EP 1 265 474 B1**
(45) Date of publication and mention of the grant of the patent: **30.01.2008**
(21) Application number: 00971814.9
(22) Date of filing: 06.11.2000
(51) Int. Cl.: H05K 13/02, H05K 13/04

(54) **METHOD AND DEVICE FOR PART FEEDING AND PART MOUNTING DEVICE USING THE METHOD AND DEVICE**
TEILEZUFÜHRMETHODE UND VORRICHTUNG UND DAMIT AUSGERÜSTETE BESTÜCKUNGSEINRICHTUNG
PROCEDE ET DISPOSITIF D'ALIMENTATION ET DE MONTAGE DE PIECES, ET UTILISATION DUDIT PROCEDE ET DUDIT DISPOSITIF

(30) Priority: 05.11.1999 JP 31538599; 05.11.1999 JP 31604099; 11.01.2000 JP 2000002746; 12.01.2000 JP 2000006268
(43) Date of publication of application: 11.12.2002
(73) Proprietor: MATSUSHITA ELECTRIC INDUSTRIAL CO., LTD, Kadoma-shi, Osaka 571-8501 (JP)
(72) Inventor: NISHIOKA, Shinichi, Matsushita Electric Ind Co Ltd, Kadoma-shi, Osaka 571-8501 (JP); ANDO, Takashi, c/o Matsushita Electric Ind Co Ltd, Kadoma-shi, Osaka 571-8501 (JP); SENO, Makito, c/o Matsushita Electric Ind Co Ltd, Kadoma-shi, Osaka 571-8501 (JP); ISHITANI, Yasuyuki, Matsushita Electric Ind Co Ltd, Kadoma-shi, Osaka 571-8501 (JP); KAWAGUCHI, Teruo, Matsushita Electric Ind Co Ltd, Kadoma-shi, Osaka 571-8501 (JP); OJI, Shiro, c/o Matsushita Electric Ind Co Ltd, Kadoma-shi, Osaka 571-8501 (JP); HATA, Kanji, c/o Matsushita Electric Ind Co Ltd, Kadoma-shi, Osaka 571-8501 (JP); KITANI, Minoru, c/o Matsushita Electric Ind Co Ltd, Kadoma-shi, Osaka 571-8501 (JP); NAGASAWA, Yuji, c/o Matsushita Electric Ind Co Ltd, Kadoma-shi, Osaka 571-8501 (JP)
(74) Representative: Haley, Stephen
(86) International application number: PCT/JP2000/007802
(87) International publication number: WO 2001/033930

(56) References cited:
- EP-A- 0 427 243
- EP-A- 0 460 834
- EP-A- 0 496 586
- EP-A- 0 876 091
- EP-A- 0 914 034
- EP-A- 0 954 212
- JP-A- 5 304 391
- JP-A- 9 046 086
- JP-A- 9 064 586
- JP-A- 10 022 693
- JP-A- 10 027 990
- US-A- 4 740 136
- US-A- 5 342 474

## Description

### TECHNICAL FIELD

The present invention relates to a component feeding method and device for feeding various components to be mounted, used in a component mounting apparatus for fabricating an electronic circuit board, for example by mounting electronic components on a circuit board, and also relates to a component mounting apparatus using such method and device.

### BACKGROUND ART

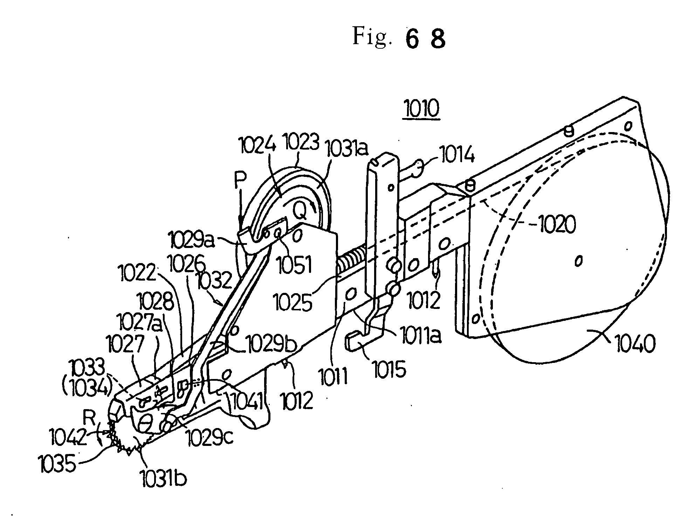

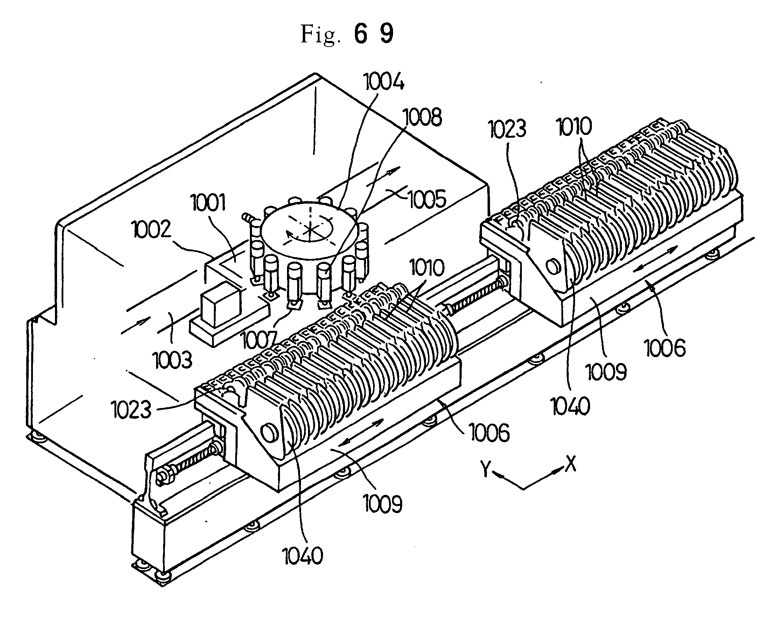

In recent years, an electronic component mounting apparatus for automatically mounting chip-type electronic components or the like on a circuit board becomes necessary and indispensable in the method of fabricating an electronic circuit board. With this, automatic feed of various kinds of electronic components is also indispensable. In Fig. 68 and Fig. 69, an example of a conventional component mounting apparatus for mounting electronic components on a circuit board is illustrated. This component mounting apparatus handles a circuit board 1001, which is provided as a target on which electronic components are mounted, by retaining it on an XY table 1002. The XY table 1002 is provided for the mounting of electronic components using a mounting head 1004 by receiving the circuit board 1001 from a carry-in unit 1003 to retain it thereon and transferring the circuit board 1001 in two directions X, Y perpendicular to each other such that, at any given time, mounting positions on which electronic components should be mounted are sequentially placed on components mounting positions on which the electronic component mounting apparatus performs the mounting operation, repeating the step of carrying an electronic circuit board where the mounting of electronic components has completed out of a carry-out unit 1005.

The mounting head 1004 is arranged such that it extends to the XY table 1002 and a components feeding unit 1006 that feeds electronic components. The mounting head 104 repeats the steps of carrying an electronic component 1007, which is required in each time and is fed by the components feeding unit 1006, by picking it up with the suction of a suction nozzle 108 or the like and mounting only a good product on a predetermined mounting position while performing the procedures of inspection, calibration, or the like. If the picked-up electronic component 1007 is a defective product or if the pick-up is missed, the mounting head 1004 may retry the mounting of an electronic component by carrying an electronic component 1007 which is one to be supplied next, again. The retry process may include the disposal of the defective product or the like if required.

This exemplified mounting head 1004 has a plurality of suction nozzles 1008 for efficient mounting, so that a mounting cycle per unit of time can be enhanced by repeating the above steps of picking up and mounting the electronic component 1007 with a phase at a time interval shorter than the mounting tact to be performed by a single suction nozzle 1008 while rotating the suction nozzles 1008 along a predetermined rotation track.

The components feeding unit 1006 has components feeding tables, which are elongated from side to side in the X direction, on both left and right sides thereof. On each of the components feeding tables 1009, there is provided a plurality of component feeding devices 1010 having narrow widths as shown in Fig. 68, arranged in the left and right directions as shown in Fig. 69. By only moving the components feeding tables 1009 from side to side, a component feeding device 1010 which can be occasionally required is located at a predetermined components feeding position as shown in Fig. 69 to allow the feed of electronic component 1007. The number of the component feeding devices 1010 being mounted on one side of the components feeding table 1009 may be about 30 to 60, or it may be in the range of 60 to 120 for both sides. In practice, it may be less or larger than such a range. Therefore, various kinds of electronic components 1007 can be automatically fed and automatically mounted in an efficient manner as occasion arises.

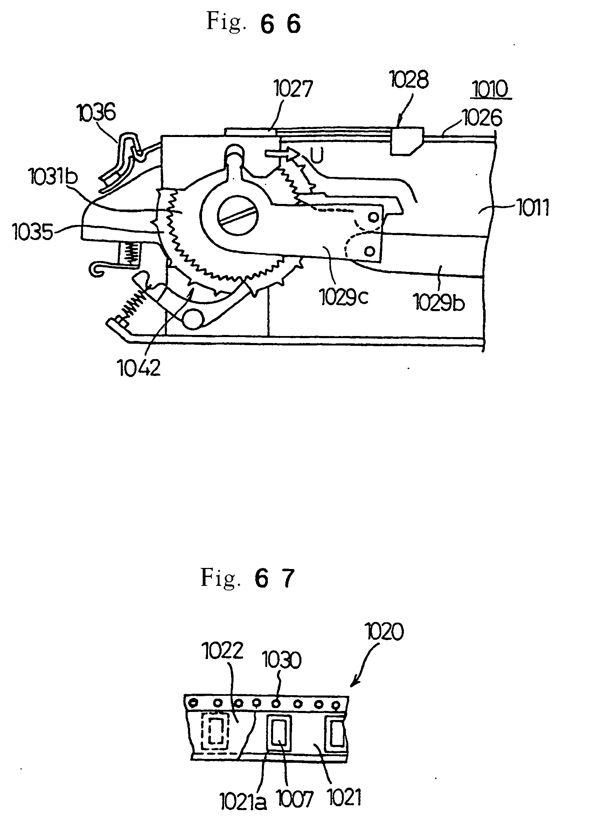

Such a component feeding device 1010 is provided for allowing a suction nozzle 1008 to pick up the electronic component 1007. As shown in Fig. 67, for example, the so-called taping component 1020 is configured such that electronic components 1007 are accommodated in storage portions 1021a aligned in the longitudinal direction of a carrier tape 1021 and are then sealed by covering with a cover tape 1022. The resulted taping component 1020 is handled as being wound on a reel 1040 and can be then exposed by pealing off the cover tape 10022 when the taping component 1020 is intermittently shifted for each pitch of component-storage to be positioned at a components feeding position before being picked up. Alternatively, not shown in the figure, there is another component feeding device which uses the so-called bulk component in which the minute electronic components 1007 are stored in random arrangements in a receptacle from which each of minute electronic components 1007 is transferred from the receptacle to the components feeding position, while keeping them in line, allowing a suction nozzle 1008 to pick up the minute electronic component 1007. In each of these component feeding devices, the width thereof enough to deal with one electronic component 1007 is only required. Therefore, it is preferable because a number of the electronic components 1007 can be aligned on the components feeding table 1009 without being bulky as shown in Fig. 69. In addition, it is easy to cope with a high implementation cycle as a distance to change the electronic component 1007 to be fed becomes small. Furthermore, there is also a taping component that accommodates electronic components being aligned in a plurality of lines.

By the way, the tip-type electronic component 1007 becomes difficult to be handled as a microminiaturization thereof proceeds in parallel to the high integration of semiconductor devices together with a demand for miniaturization of the product. In addition, electronic equipments having electronic circuit boards become widely available in a remarkable manner, and the increase in productivity and the decrease in cost by speeding up have been strongly desired. On the other hand, the improvement in packaging precision has been also desired for improving the performances of the electronic equipment and the packaging density.

These demands may be conflicted with each other, so that it will not easy to satisfy these demands at once. For instance, the component feeding device 1010 should be replaced when all of the electronic components 1007 are used. In addition, a number of the component feeding devices 1010 should be replaced when there is a change in product category. More component feeding devices 1010 are used, the more time is required for replacing them. Therefore, the productivity can be significantly influenced. Furthermore, if the feed of electronic components 1007 from each component feeding device 1010 is not stable, the productivity can be decreased as the mounting operation is reattempted due to the miss feed of components, the mounting operation is reattempted due to the mounting mistake related to the miss feed, useless production of a defective product by mounting mistake, or the like. In addition, production costs increase as the yields decrease with the generation of defective products.

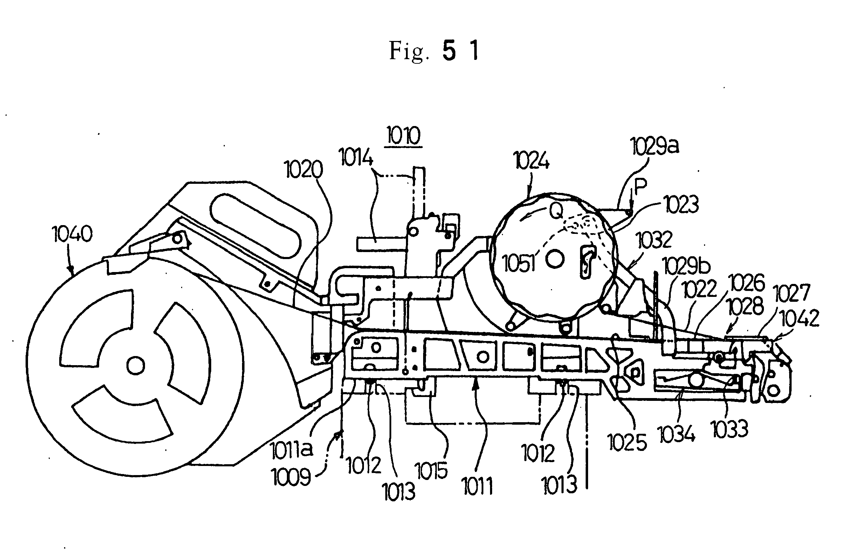

By the way, the component feeding devices 1010 shown in Fig. 51 and Fig. 68 deal with their respective taping components 1020 as described above. Therefore, their components feeding functions can be substantially common with each other and they can be attached on and detached from their respective components feeding tables 1009 by the same mode. For this mode for attachment and detachment, the same reference numerals are applied to the components of the component feeding device 1010 shown in Fig. 51, which are substantially common with those of the component feeding device 1010 shown in Fig. 68, to make an explanation thereof while omitting overlapped description. As shown in Fig. 51, positioning pins 1012 are provided on the front and back in the longitudinal direction of the device main body 1011, i.e., in the Y direction, respectively. The positioning is attained by fitting the positioning pins 1012 into a pair of positioning holes 1013 on the front and back sides of the components feeding table 1009. Subsequently, under such a positioning condition, a lever 1014 equipped in the device main body 1011 is tilted from an uprising position represented by a phantom line to a horizontal position represented by a solid line. The component feeding device 1010 can be fixed in a state of being positioned as described above as a hook 1015 becomes in a state of sandwiching the components feeding table 1009 between the hook 1015 and the under surface 1011a of the device main body 1011.

However, for mounting the component feeding device 1010 on the components feeding table 1009 using such a method, a complicated work for positioning a pair of the positioning pins 1012 into the positioning holes 1013 of the components feeding table 1009 and fitting them along their axial lines is required. In addition to this, the lever 1014 should be then operated, resulting in poor workability and preventing the improvement in productivity at the time of initial attachment, replacement, or the like.

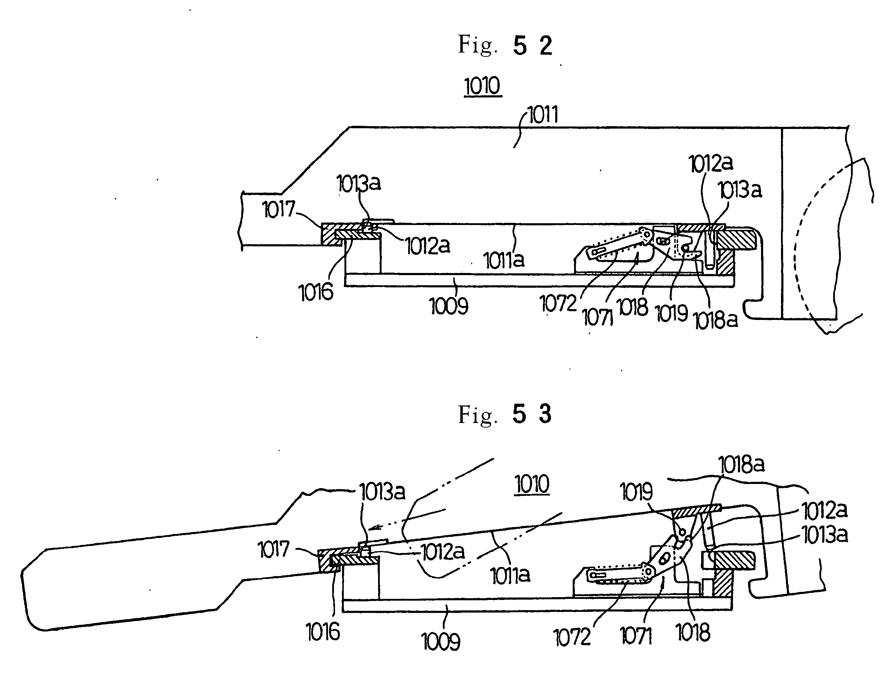

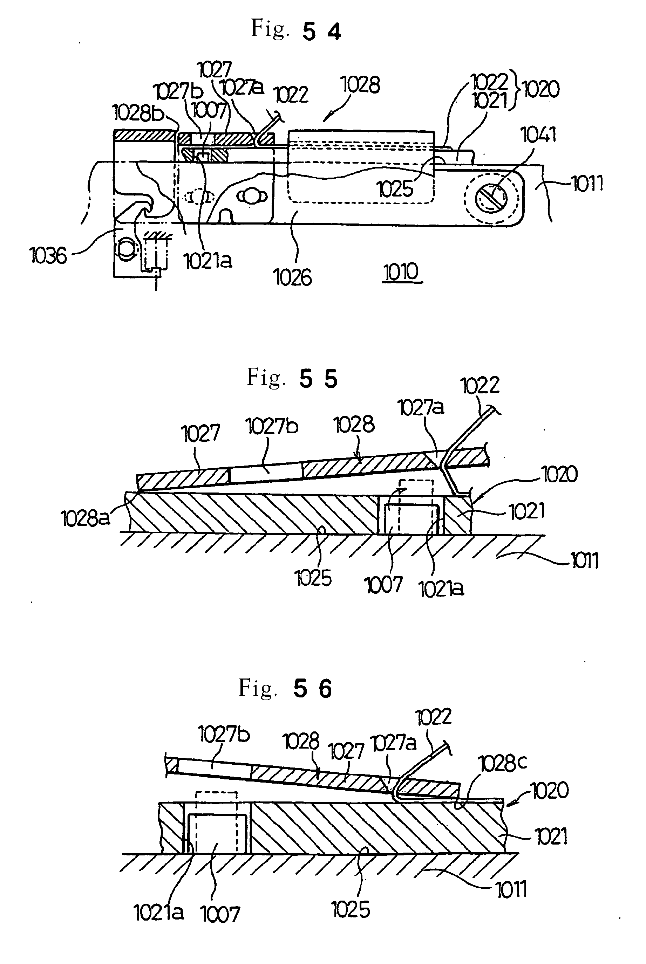

On the other hand, the component feeding device 1010 to be mounted using another method as shown in Fig. 52 and Fig. 53 has been already provided. Such a component feeding device 1010 adapts the positioning method by slightly easy fitting between a pair of the positioning pins 1012a and the front and back recessed portions 1013a oppositely opened, as shown in Fig. 52. For mounting the component feeding device 1010, at first, an engaging portion 1017 shaped like a hook facing backward and formed on an under surface 1011a of the device main body 1011 is moved toward an engaging portion 1016 facing forward with respect to the components feeding table 1009, while the device main body 1011 is moved backward, allowing them to engage with each other from the front side while fitting between the front side positioning pin 1012a and the positioning recessed portion 1013a. Next, the rear side of the device main body 1011 is pushed to and mounted on the components feeding table 1009 while fitting between the back side positioning pin 1012a and the positioning recessed portion 1013a to satisfactory complete fitting between the front and back positioning pins 1012a and the positioning recessed portions 1013a.

In particular, at the time of pushing the back portion of the device main body 1011 to the top of the components feeding table 1009, a shaft 1019 for fixation, which is provided on the under surface 1011a of the device main body 1011, is energized by means of a spring 1072 through a toggle mechanism 1071 on the side of the components feeding table 1009 and is fitted with a two-forked tip portion 1018a of a retaining link 1018 in an upwardly inclined position to push it down. Therefore, the retaining link 1018 becomes pushed down from the upwardly inclined position against the spring energization, during which energization by the spring 1072 becomes pushed down from the state shown in Fig. 53 to the state shown in Fig. 52 by the toggle mechanism 1071. During these events, the energization of the spring 1072 becomes reversely acted toward the downwardly inclined position which is opposite to the above position. From this time, the retaining link 1018 downwardly pulls the fixing shaft 1019 engaged with the two-forked tip portion 1018a to automatically fix the component feeding device 1010 by attracting the device main body 1011 to the components feeding table 1009 under the positioning condition.

Accordingly, in the component feeding device 1010 shown in Fig. 52 and Fig. 53, the engaging portion 1017 on the front side of the component feeding device 1010 is engaged with the engaging portion 1016, followed by pushing the rear side thereof down to make an engagement between two positioning pins 1012a and two respective positioning recessed portions 1013a to provide them in place, while the shaft 1019 is strongly energized downward with the retaining link 1018 and is then held on the components feeding table 1009. Therefore, the component feeding device 1010 can be attached and surely fixed by means of a one-touch operation.

However, in this component mounting apparatus 1010, the engaging portion 1016 of the components feeding table 1009 to be engaged with the engaging portion 1017 formed on the front side thereof protrudes upward. Therefore, there may be cases that an operation is disturbed as the front end portion of the component feeding device 1010 catches on or comes into collision with the engaging portion 1016 when the component feeding device 1010 slanted downward as represented by the phantom line in Fig. 52 is moved over the components feeding table 1009. In addition, if the front end portion of the component feeding device 1010, on which mechanical components such as springs are arranged, is damaged at that time, the mounting operation should be retried with a replacement of the component feeding device 1010. Therefore, too much time will be spent and the productivity will be influenced greatly. Furthermore, if the component feeding device 1010 is damaged, it should be repaired or should be discarded. Therefore, the administrative and maintenance expense of equipment will be increased. This increase the equipment cost and also affects the product cost.

In the case of making the fixed shaft 1019 of the component feeding device 1010 to engage with the retaining link 1018, if the retaining link 1018 is, for example, brought down so as to be reversely slanted as shown in Fig. 52 against user's will, it should be brought back to its original position, otherwise the shaft 1019 cannot be engaged with. In addition, the operation for replacing the retaining link 1018 back is complicated and is a time-consuming job, so that the productivity can be influenced very much. Furthermore, fixing means for supporting and energizing in such a toggle mechanism 1071 includes a lot of components, so that the equipment cost can be increased, affecting the product cost.

The component feeding device 1010 shown in Fig. 68 includes: an intermittent driving mechanism 1042 for intermittently transferring a taping component 1020 by engaging with its perforations 1030; a cover tape winding-up mechanism 1024 including a reel 1023 for winding up a cover tape 1022 of the taping component 1020; a tape presser 1028 including an arm 1026 and a shutter 1027, which is rotatable about a shaft 1046 to move between an operation position where it is in contact with a tape guide 1025 formed by the upper surface of the device main body 1011 and a release position where it extends upwardly from the device main body 1011; a driving mechanism 1032 including arms 1029a to 1029c, ratchet wheels 1031a, 1031b, and so on, for intermittently moving the taping component 1020, opening the shutter 1027 of the tape presser 1028, and rotating the reel 1023, respectively; a push-out mechanism 1034 including a push rod 1033 for upwardly pushing an electronic component 1007 out of a recessed portion 1021a of a carrier tape 1021; and so on, which are built in the device main body 1011.

The taping component 1020 can be loaded in a state that the tape presser 1028 is turned to the release position. At first, the taping component 1020 is reeled out of the reel 1040 equipped on the rear end portion of the device main body 1011 to move it along the surface of a tape guide 1025 toward the frond end thereof. Then, after passing through between the tape presser 1028 at the release position and the tape guide 1025, it reaches to the tip of the device main body 1011 and allows the perforations 1030 to engage with a sprocket wheel 1035 of the intermittent mechanism 1021 located thereon. On the other hand, at the time of passing the taping component 1020 through between the tape presser 1028 and the tape guide 1025, the cover tape 1022 is removed from the carrier tape 1021 of the taping component 1020 and the tip of the cover tape 1022 is pulled out through a slit 1027a formed in the shutter 1027 so as to be connected with the reel 1023 and to be then wound thereon. In conjunction with this, the tape presser 1028 is turned to the operation position while the tape presser 1028 is locked at the operation position by a latch mechanism 136 as shown in Fig. 66.

Such a kind of the operation for mounting the taping component 1020 is dependent on the labor of a person, so that it is difficult to expect the person to always install the taping component 1020 in the component feeding device 1010 with reliability and to expect the tape presser 1028 to be always locked at the operation position. Furthermore, if the tape presser 1028 is not locked or the tape presser 1028 is not set at the operation position, it cannot be easily detected. Still more, it has not been automatically detected. Therefore, if at least one of the component feeding devices 1010 having such an error is used without recognizing such an error, the tape presser 1028 becomes lifted, causing interference with the electronic-component mounting apparatus during the movement of the component feeding device 1010 and damaging them each other, or making the mistake of feed or disabling the feed as the electronic component 1007 cannot be fed effectively. The damaged component feeding device 1010 should be replaced with another one to restore, and the damaged electronic-component mounting apparatus should be subjected to making repairs on a damaged portion thereof. However, either case may result in the shutdown of the electronic-component mounting apparatus. During the process of repair, the electronic component device is being shut down. In addition, the replacement of the component feeding device 1010, including the preparation of another one, cannot be completed within a short time. Therefore, the productivity can be considerably affected. Furthermore, making the mistake with feeding components or becoming impossible to feed the components affect on the productivity because of reconsidering the feed of electronic components or cause the decrease in the yields of the electronic components and products because of causing the mounting mistakes.

For tape presser 1028, as shown in Fig. 54, a central position for turning around the shaft 1041 is selected so that it is pressed on the tape guide 1025 along the taping component 1020 at the operation position.

However, the pressing position of the tape guide 1025 is varied depending on the change in the thickness of the carrier tape 1021. If an appropriate position shown in Fig. 54 is defined such that it can be obtained using a carrier tape 1021 with an average thickness, in the case of a thin carrier tape 1021, the tip side portion of the tape presser 1028, the tip portion 1028a of the shutter 1027 in the case of shown in the figure, is turned as far as it touches the carrier tape 1021 and is then stopped. Thus, the tape presser 1028 is in a state of pushing the carrier tape 1021 and the taping component 1020 while being tilted forward. Therefore, a gap between the tape presser 1028 and the carrier tape 1021 is gradually increased from the front to the rear of the tape presser 1028 and it becomes great in particular in the vicinity of a peeled portion of the cover tape 1022. Therefore, the electronic component 1007 accommodated in the storage portion 1021a is turned as indicated by the broken line by vibration accompanied by the operation of intermittently transporting the electronic component 1007, so that there is a risk of missing out on the feed of electronic component 1007 at an appropriate position.

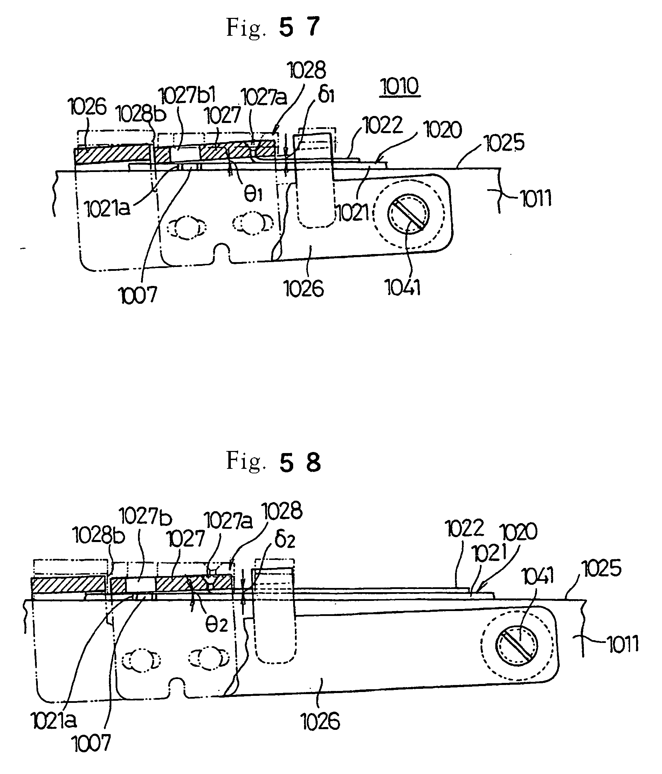

On the contrary, when the carrier tape 1021 is thick, the rear end portion of the tape presser 1028 as shown in Fig. 56, i.e., the rear end portion 1028c of the shutter 1027 shown in the figure is turned as far as it touches the tape component 1020, resulting in a state 2 in which it pushes the carrier tape 1021 and the taping component 1020 while being tilted backward. Therefore, a gap between the tape presser 1028 and the carrier tape 1021 is gradually increased from the rear to the front of the tape presser 1028 and it becomes great in particular between the carrier tape 1021 and the tape presser 1028 in the vicinity of a window portion 1028b used for bringing out the electronic component 1007. Therefore, the electronic component 1007 is turned in the hollow portion 1021a by vibration accompanied by the operation of intermittently transporting the electronic component 1007, so that there is a risk of missing out on the normal extract of electronic component 1007.

In each of the above cases, the electronic component 1007 cannot be fed in an appropriate manner, so that it can be in a state of making a mistake in the feed or of disabling the feed. As described above, the yields can be decreased by a mistake in mounting electronic components on the electronic circuit board and the time loss is caused by re-mounting operation, resulting in the decrease in the productivity.

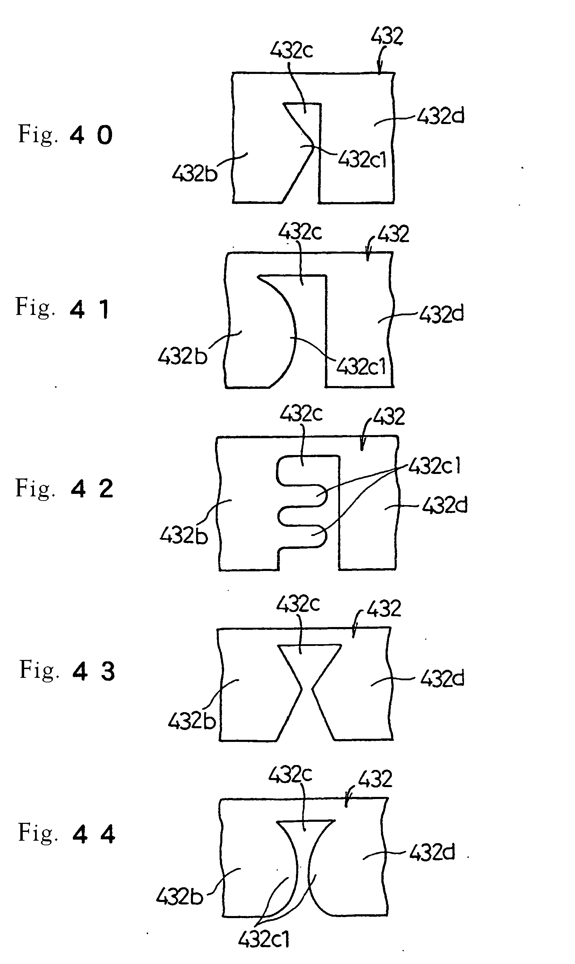

For solving such a problem, as shown in Fig. 58, it is conceivable that the turning center position of the shaft 1041 of the tape presser 1028 is defined to sufficiently reward of a portion of the shutter 1027 for the general design example shown in Fig. 57 to prevent the tilt angle of the tape presser 1028 from being varied with respect to the variations in thickness of the carrier tape 1021. For instance, when the carrier tape 1021 is thin, as indicated by a solid line, the tilt angle of the tape presser 1028 with respect to the carrier tape 1021 can be made smaller from θ₁ as shown in Fig. 43 to θ₂ as shown in Fig. 44. In addition, the maximum gap between the tape presser 1028 and the carrier tape 1021 can be made smaller from δ₁ as shown in Fig. 43 to δ₂ as shown in Fig. 44. It is an effect as a result of a large distance from the contact point between the tape presser 1028 and the carrier tape 1021 to the shaft 1041, preventing the electronic component 1007 from being rotated or vibrated to allow it to be brought out properly. In addition, in the case of the thick carrier tape 1, it is conceivable that the tilt angle thereof may be also made smaller and the gap may be also made smaller even though it is tilted in the reverse direction.

However, as shown in Fig. 58, when a position of the shaft 1041 of the tape presser 1028 moves backward, the tape presser 1028 becomes elongated and enlarged, resulting in a problem in which the cost becomes increased to maintain the component's accuracy.

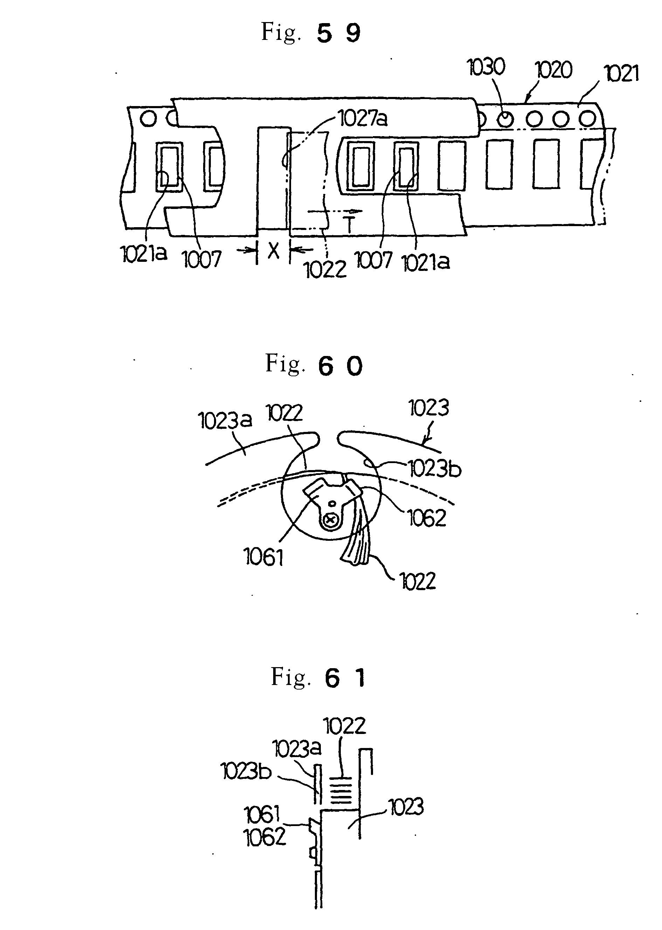

In Fig. 51, Fig. 65, and Fig. 68, the drive mechanism 1032 allows the shutter to move backward in the direction indicated by the arrow V as shown in Fig. 66 by oscillation mainly on the shaft 1051 which is caused when the lever 1029a near a cover-tape winding mechanism 1024 is pushed down in the P direction from the electronic-component mounting apparatus side. Thus, a components feeding opening 1028b of the components-presser 1028 or the carrier tape 1021 is opened as it corresponds to an opening portion 1027b of the shutter 1027, allowing the fed electronic component 1007 to be brought out. After that, at the time that the lever 1029a released from the above depression is reversely oscillated by being energized with a spring 1050, the reel 1023 is turned in the direction of the arrow Q through the cover-tape winding mechanism 1024 including a ratchet wheel 1031a, such that the cover tape 1022 is wound on in the direction of the arrow T as shown in Fig. 59 and Fig. 64. Simultaneously with rotationally actuating the sprocket wheel 1035 in the direction of the arrow R through the levers 1029b, 1029c and the intermittent driving mechanism 1042 to pitch-feed the taping component 1020 in the direction of the arrow S in Fig. 64, the components feeding opening 1028b and the recessed portion 1021 are closed by moving the shutter 1027 in the direction of the arrow S, while synchronizing with this the cover tape 1022 is peeled off of the carrier tape 1021 together with winding the cover tape 1022 on the reel 1023 as indicated by the arrow T.

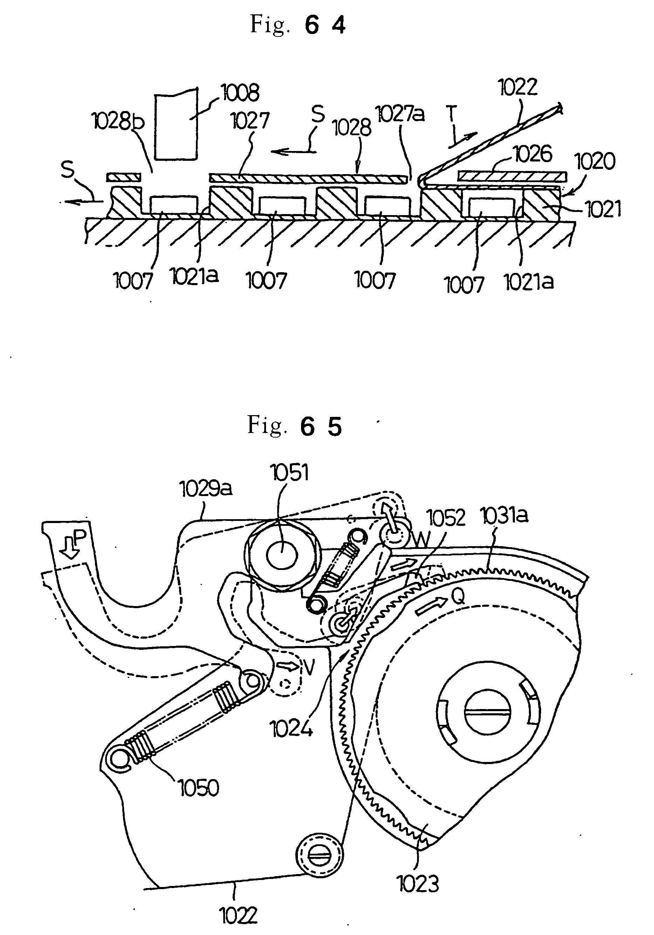

Here, the behavior of the cover tape winding-up mechanism 1024 under such an operation will be described. The lever 1041 oscillates in the direction of the arrow Q as shown in Fig. 65 when it is pushed down in the direction of the arrow P to allow a winding claw 1052 axially supported by one end portion of the lever 1029a to move in the direction of the arrow W as shown in Fig. 65. Then, the winding claw 1052 is engaged with the ratchet wheel 1031a, so that it becomes pressed and moved in the direction of the arrow W to turn the reel 1023 in the direction of the arrow Q through the ratchet wheel 1031a. When the lever 1029a is released from being pushed down and is then reversely moved, the winding claw 1052 makes a press-contact with the reel 1023 and moves backward in the direction opposite to the direction of the allow W without reversely rotating the reel 1023 in the direction opposite to the direction of the arrow Q, allowing the lever 1029a and the winding claw 1052 to return to their initial positions.

However, in such a cover tape winding-up mechanism 1024, the winding claw 1052 is engaged with one of teeth of the ratchet wheel 1031a to rotate for a predetermined distance in the direction of the arrow Q, followed by repeating a sliding movement across teeth of the ratchet wheel 1031a one by one when it is returned to its initial position. Therefore, the winding claw 1052 is always fit to or contact to the ratchet wheel 1031a, and at the time of returning movement, an abnormal noise can be generated by surely moving over several teeth. The wearing or defect of the winding claw 1052 or the ratchet wheel 1031a can also be easily generated. When the winding claw 1052 or the ratchet wheel 1031a is broken or the like, the winding cannot be normally performed. In addition, due to a delay in winding up to be caused by a delay in engaging with the winding claw 1052, there is a possibility of failing the winding of cover tape 1022. Therefore, there is a need to perform maintenance at frequent intervals, so that the productivity can be decreased.

For improving the productivity of the electronic-component mounting apparatus, when a tact time for feeding the components in each of the component feeding device 1010 in accordance with speeding up of a mounting cycle in the component mounting apparatus is speeded up, the speed and cycle of pushing the lever 1029a down, i.e., the speed and cycle of moving the shutter 1027 backward become increased, while the speeds of returning movements of the lever 1029a and the cover-tape winding mechanism 1024 are still constant by being energized by the spring 1050, resulting in a delay in peeling the cover tape 1022 from the carrier tape 1021. Therefore, there is a possibility that the cover tape 1022 is jammed as a result of getting under the shutter 1027 as shown in Fig. 63. This can be easily occurred as the width X of a slit 1027a of the shutter 1027 is narrowed. Such an event brings the electronic-component mounting apparatus down for jam processing. Even if it does not stop, the productivity can be affected because there is a need to feed and mount an electronic component again as a result of a mistake in the feed thereof. In addition, the yields of electronic components and products can be decreased.

Furthermore, if the width X of the above slit 43 is simply increased, the cover tape 1022 can be easily peeled off in time and the jam becomes hardly occurred. As the cycle time of mounting the electronic component 1007 is increased, the speeds of moving the components feeding table 1009 and the component feeding device 1010 are increased. Because of this, the electronic component 1007 becomes easily flown out of the slit 1027a under the influence of the inertia or vibration of the electronic component 1007. It becomes a problem in that the productivity is affected as the component should be fed and mounted again because of a mistake in the component feed and the yields of components and products are decreased. In addition, there is another problem where the equipment can be damaged as the electronic component 1007 may be engaged in each portion as the electronic component 1007 flies out.

Finally, when the cover tape 1022, which is peeled off from the carrier tape 1021 of the taping component 1020 and is then pulled out of the slit 1027a of the shutter 1027 as shown in Fig. 59 and Fig. 64, is wound around the real 1023 at first, the end of the cover tape 1022 is wound around the reel 1023 and is then passed through the slit 1023b of the winding cap 1023a and pulled out to the outer surface, followed by engaging it in one of the retaining claws 1061, 1062 formed on the reel 1023 as shown in Fig. 60 and Fig. 61 so that the cover tape 1022 can be wound around the reel 1023 in either left-handed direction or right-handed direction. After that, an excess cover tape 1022 is cut off with a tool such as scissors.

In this kind of the conventional procedures, when the tip of the peeled cover tape 1022 is pulled out of the slit 1023b of the reel 1023 and is then fixed, two steps of the work are required, where the cover tape 1022 is clipped in the retaining claws 1061, 1062 and an excess portion of the cover tape 1022 is then cut off. Thus, there is a need to prepare a tool such as scissors in advance.
Therefore, the work for fixing the cover tape 1022 takes a lot of trouble, so that it can be resulted in poor workability and poor working efficiency and it becomes obstruction of the improvement in productivity.

A main object of the present invention is to provide a component feeding method and device by which components can be effectively and efficiently fed and the productivity can be increased, and to provide a component mounting apparatus using them.

The present invention provides a component feeding device comprising:
a component feeding part wherein a component carrying tape constituted by a tapelike member having accommodating spaces formed at a predetermined pitch in a lengthwise direction of the tapelike member for accommodating components therein, the components being covered by a cover tape, is fed at a predetermined pitch and the cover tape is peeled off before a component feeding position; and
a cover tape winding-up device for winding up the peeled-off cover tape, wherein
the component feeding part includes a shutter having a slit through which the cover tape peeled off from the component carrying tape is passed and drawn out, characterised in that cover tape winding-up device includes a winding-up reel for winding the peeled-off cover tape, and a locking claw for holding the cover tape between the winding-up reel, and having an edge for cutting cue cover tape.

As the component feeding device is configured as described above, the first retaining means engages with the first engaging means at a position where it is not protruded from the upper surface of the holding portion which holds the first retaining means to allow each of component feeding devices to be retained and fixed at a mounting position to the components feeding table. Therefore, when the component feeding device is moved forward over the holding portion of the first retaining means and the components feeding table while the front end portion of the component feeding device is inclined downward, the front end side of each component feeding device does not interface with the first engaging means, while the first engaging means engages with the first retaining means and is fixed as described.

That is, the front end portion of each component feeding device is moved smoothly without causing any trouble on the holding portion of the first retaining means. In addition, the first engaging means and the first retaining means are engaged with each other. Therefore, the workability becomes excellent. In addition the problem of causing damage by interference can be solved.

By the way, a first positioning pin and a first positioning hollow portion, which are fitted with each other at the time of engaging the first retaining means with the first engaging means, may be provided to attain the positioning on the front end side of each component feeding device without impairing the workability and operability.

Furthermore, the component feeding device of the present invention is characterized by comprising: an individual component feeding device which transfers a component to a predetermined position to feed it; and a components feeding table on which second retaining means to be engaged with second engaging means provided on a rear portion of a main body at the time of mounting the individual component feeding device, wherein the second retaining means includes: a retaining member capable of moving back and forth, with which the second engaging means to be moved downward when the rear end side of the individual component-supplying device is pushed against the components feeding table is engaged; and energizing means for energizing the retaining member to keep the engaging position.

If the component feeding device is configured as described above, the second engaging means pushes the rear end side of the individual component feeding device against the components feeding table. If it touches on the engaging portion of the retaining member of the second retaining member, the retaining member is pushed backward against the energization of the energizing means. After that, when the second engaging means moves across the engaging portion of the retaining member, the retaining member performs a returning movement forward by the energizing force of the energizing means. Consequently, the second engaging means is retained in the second retaining means.

Therefore, as the rear end side of the individual component feeding device is pushed down to retain the second engaging means with the second retaining means, the component feeding device can be surely fixed by one-touch operation. In addition, even though the rear end side of the individual component feeding device is pulled upward to remove the second engaging means from the retaining member for removing the individual component feeding device, the second retaining means can be returned at once by the energization of the energizing means, resulting in an operation-allowable state. Therefore, there is no possibility that the second retaining means carelessly becomes an operation-impossible state.

By the way, a second positioning pin and a second positioning hollow portion, which are fitted with each other at the time of engaging the second retaining means with the second engaging means, may be provided to attain the positioning on the front end side of each component feeding device without impairing the one-touch operation.

The present invention is allowed to provide a component mounting apparatus having a combination of each component feeding device described above and a components mounting mechanism for fabricating a product by repeating the steps of holding a component to be fed from the component feeding device by sucking and mounting it on a mounting target. Therefore, the replacement of individual component feeding device needed by the preparation of the predetermined components feeding condition, shortage, damage, change in product class, and so on can be performed with good initial setup, so that the product can be fabricated at an excellent productivity.

As the component feeding device is configured as described above, when the driving force transmitting unit moves the wind-up gear in the direction of winding up the cover tape along the outer periphery of the winding reel through the supporting shaft of the wind-up gear, the second one way clutch keeps the wind-up gear in a state of stopping the driven rotation caused by engaging with the winding reel in the supporting shaft, and a rotational force in the direction winding up the cover tape is imparted on the winding reel by hooking with teeth on the outer periphery of the winding reel of the wind-up gear. At this time, the first one way clutch allows the winding reel to rotate in the direction of winding up the cover tape around the supporting shaft thereof so that the cover tape is wound on the winding reel.

When the wind-up gear is returned to its initial state by the driving force transmitting unit, the first one way clutch permits a driven rotation of the wind-up gear with the wind reel on the supporting shaft, while the second one way clutch stops the rotation of the winding reel in the direction of returning movement by engaging with the wind-up gear in the supporting shaft so that the wind-up gear turns freely and returns to the initial position. As the winding reel is stopped as described above, the cover tape once wound up is prevented from rewinding by returning movement of the wind-up gear to the initial position. The cover tape can be surely wound up as much as the moving distance of the wind-up gear only when the wind-up gear performs an outgoing movement in the direction of winding up the cover tape.

Accordingly, the winding reel and the wind-up gear are always connected with each other through the engagement of gears, so that a delay in rotation and a delay in winding up caused by the former at the time of initiating the rotation or the like are hardly occurred. Also, the engagement is performed between the gears, so that it can be smoothly occurred and noiseless can be attained. Particularly, there is no behavior in which one tooth moves across the other tooth while pressing against it. Thus, abrasion and defection are hardly occurred, so that the durability can be increased. Consequently, productivity deterioration for components feeding defectiveness and maintenance, and the decrease in yields of components and products can be prevented.

### BRIEF DESCRIPTION OF THE DRAWINGS

Fig. 1 is a partially cross sectional front view in a relation between a cassette-type component feeding device in accordance with a first embodiment of the present invention and a components feeding table that mounts such a device and feeds electronic components to an electronic-component mounting apparatus, illustrating a state of the above mounting;
Fig. 2 is an enlarged and exploded perspective view of first engaging means and first retaining means in Fig. 1;
Fig. 3 is an enlarged and exploded perspective view of second engaging means and second retaining means in Fig. 1;
Fig. 4 is an enlarged and exploded perspective view for illustrating another example of the second retaining means;
Fig. 5 is a side view of the second retaining means in Fig. 4;
Fig. 6 is an enlarged and exploded perspective view for illustrating still another example of the second retaining means;
Fig. 7 is a cross sectional view of the second retaining means in Fig. 6;
Fig. 8 is a side view that illustrates the step of mounting the component feeding device on the components feeding table, viewing in a state of prior to engage the first engaging means with the first retaining means shown in Fig. 1 to Fig. 3;
Fig. 9 is a side view that illustrates the step of mounting the component feeding device on the components feeding table, viewing in an initial state of engaging the first engaging means with the first retaining means shown in Fig. 1 to Fig. 3;
Fig. 10 is a side view that illustrates the step of mounting the component feeding device on the components feeding table, viewing in a state of after engaging the first engaging means with the first retaining means shown in Fig. 1 to Fig. 3;
Fig. 11 is an enlarged side view viewing in a state of directly prior to engage the second engaging means with the second retaining means shown in Fig. 1 to Fig. 3;
Fig. 12 is a side view viewing in a state of after engaging the second engaging means with the second retaining means shown in Fig. 1 to Fig. 3;
Fig. 13 is a perspective view that illustrates a representative embodiment of an electronic-component mounting apparatus having the components feeding tables on which the component feeding devices are individually mounted, where the electronic components are fed and are mounted on a circuit board to fabricate an electronic circuit board;
Fig. 14 is a side view of a principal part, illustrating the component feeding device dealing with a taping component in accordance with a second embodiment of the present invention;
Fig. 15 is a traverse sectional view of the component feeding device;
Fig. 16 is a side view for illustrating the details of the principal part of the component feeding device;
Fig. 17 is a plan view of a tape presser portion of the component feeding device dealing with the taping component in accordance with a third embodiment of the present invention;
Fig. 18 is a cross sectional view of the tape presser portion;
Fig. 19 is a side view of the tape presser portion;
Fig. 20 is a cross sectional view along the line XX-XX in Fig. 19;
Fig. 21 is a cross sectional view for illustrating a state in which a thick taping component is pressed by the tape presser portion;
Fig. 22 is a cross sectional view for illustrating a state in which a taping component with a medium thickness is pressed by the tape presser portion;
Fig. 23 is a cross sectional view for illustrating a state in which a thin taping component is pressed by the tape presser portion;
Fig. 24 is a perspective view for illustrating the component feeding device dealing with the taping component in accordance with a fourth embodiment of the present invention;
Fig. 25 is an enlarged side view for illustrating a cover-tape winding mechanism portion of the component feeding device;
Fig. 26 is a cross sectional diagram taken along the line XXVI-XXVI in Fig. 25;
Fig. 27 is a cross sectional diagram taken along the line XXVII-XXVII in Fig. 25;
Fig. 28 is a cross sectional diagram taken along the line XXVIII-XXVIII in Fig. 25;
Fig. 29 is a side view that illustrates an operative condition of the cover-tape winding mechanism portion, viewing in a state prior to a winding operation;
Fig. 30 is a side view that illustrates an operative condition of the cover-tape winding mechanism portion, viewing in a state of during the winding operation;
Fig. 31 is a side view that illustrates an operative condition of the cover-tape winding mechanism part, viewing in a state of during the returning movement;
Fig. 32 is a cross sectional view that illustrates an example of a double-type component feeding device, corresponding to Fig. 27;
Fig. 33 is a perspective view that illustrates an operative condition of the intermittent driving mechanism part of Fig. 32;
Fig. 34 is a perspective view that illustrates the operative condition of the intermittent driving mechanism portion shown in Fig. 32, viewing in an operative state of winding the cover tape before intermittently feeding the taping component and moving the shutter backward;
Fig. 35 is a perspective view that illustrates an operative condition of the intermittent driving mechanism portion in Fig. 32, viewing in a pitch-feed state of the taping component;
Fig. 36 is a cross sectional view of the tape-presser portion corresponding to Fig. 33;
Fig. 37 is a cross sectional view of the tape-presser portion corresponding to Fig. 34;
Fig. 38 is a cross sectional view of the tape-presser portion corresponding to Fig. 35;
Fig. 39 is a perspective view for illustrating a relation between the shutter of the intermittent driving mechanism and the taping component in Fig. 32;
Fig. 40 is a plan view that illustrates one of modified examples of the slit formed in the shutter;
Fig. 41 is a plan view that illustrates another example of the slit formed in the shutter;
Fig. 42 is a plan view that illustrates another example of the slit formed in the shutter;
Fig. 43 is a plan view that illustrates still another example of the slit formed in the shutter;
Fig. 44 is a plan view that illustrates still another example of the slit formed in the shutter;
Fig. 45 is a plan view that illustrates still another example of the slit formed in the shutter;
Fig. 46 is a side view showing the shape of a winding cap of the winding reel in Fig. 24;
Fig. 47 is a bottom view of the winding cap in Fig. 46;
Fig. 48 is an enlarged perspective view of the principal part of a cover-tape winding portion of the winding cap in Fig. 47;
Fig. 49 is a front view showing the shape of a retaining claw of the cover tape in the winding cap shown in Fig. 46 and Fig. 47;
Fig. 50 is a perspective view for illustrating an appearance where the cover tape is inserted between a leading groove in a guide groove of the winding cap and a slanted portion of the retaining claw in Fig. 47 and Fig. 48;
Fig. 51 is a side view that illustrates one of examples of a mounting structure in which the conventional cassette-type component feeding device is mounted on its components feeding table;
Fig. 52 is a cross sectional view that illustrates another example of a mounting structure in which the conventional cassette-type component feeding device is mounted on its components feeding table, viewing in a state of being mounted;
Fig. 53 is a cross sectional view that illustrates the mounting structure in which the cassette-type component feeding device is mounted on its components feeding table as shown in Fig. 52, viewing in a state of being retained on the front end side;
Fig. 54 is a side view of the principal part, illustrating a normal state of the tape presser in the conventional component feeding device;
Fig. 55 is a cross sectional view of the shutter portion, illustrating a state where the thin taping component is pressed by the tape presser shown in Fig. 54;
Fig. 56 is a cross sectional view for illustrating a state where the thick taping component is pressed by the tape presser shown in Fig. 54;
Fig. 57 is a cross sectional view for illustrating a state of pressing the tape by a tape presser which is normally designed;
Fig. 58 is a cross sectional view for illustrating a state of pressing the tape by a tape presser which is specially designed;
Fig. 59 is a plan view of the tape presser portion in the conventional component feeding device;
Fig. 60 is a side view of a cover-tape retaining portion of the winding reel for winding up the cover tape in the conventional component feeding device;
Fig. 61 is a cross sectional view of the retaining portion of the winding reel;

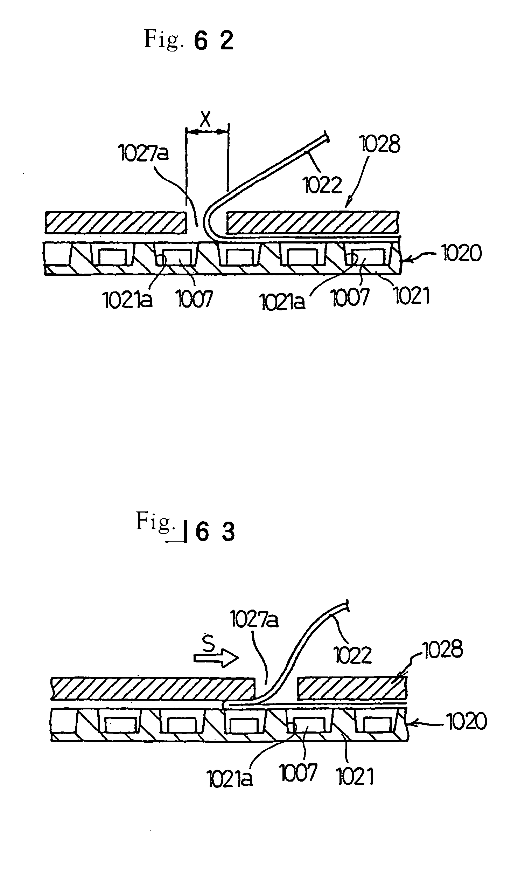

Fig. 62 is a cross sectional view for illustrating a normal state of the tape presser portion in Fig. 59;
Fig. 63 is a cross sectional view for illustrating a state of causing jam of the cover tape in the tape presser portion in Fig. 59;
Fig. 64 is an explanatory view for illustrating an operative condition of the tape presser portion in Fig. 59;
Fig. 65 is a side view for illustrating a cover-tape winding mechanism for winding up the cover tape, in conjunction with the tape presser portion in Fig. 59;
Fig. 66 is a side view for illustrating the tape presser portion and the intermittent driving mechanism that performs a pitch-feed of the taping component, in conjunction with the tape presser portion in Fig. 59 and the cover-tape winding mechanism in Fig. 65;
Fig. 67 is a plan view of the taping component shown in Fig. 62, Fig. 63, and Fig. 64;
Fig. 68 is a perspective view for illustrating one of examples of the conventional component feeding device which comprises a tape presser portion, a winding reel, a cover-tape winding mechanism, and an intermittent driving mechanism as shown in Fig. 59 to Fig. 66, for dealing with the taping component shown in Fig. 67 to feed the electronic component; and
Fig. 69 is a perspective view for illustrating one of examples of the conventional electronic-component mounting apparatus having a components feeding table on which a number of component feeding devices shown in Fig. 68 and fabricating an electronic circuit board by mounting electronic components fed from each component feeding device on a circuit substrate.

### BEST MODE FOR CARRYING OUT THE INVENTION

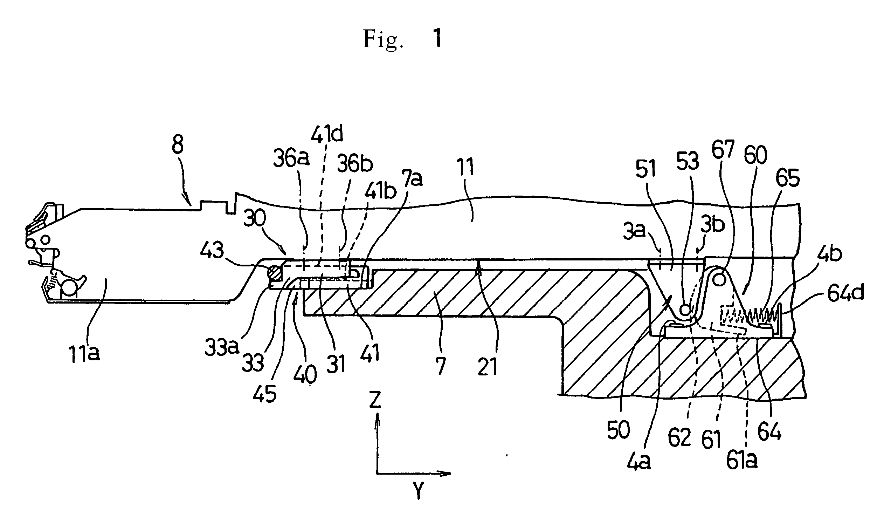

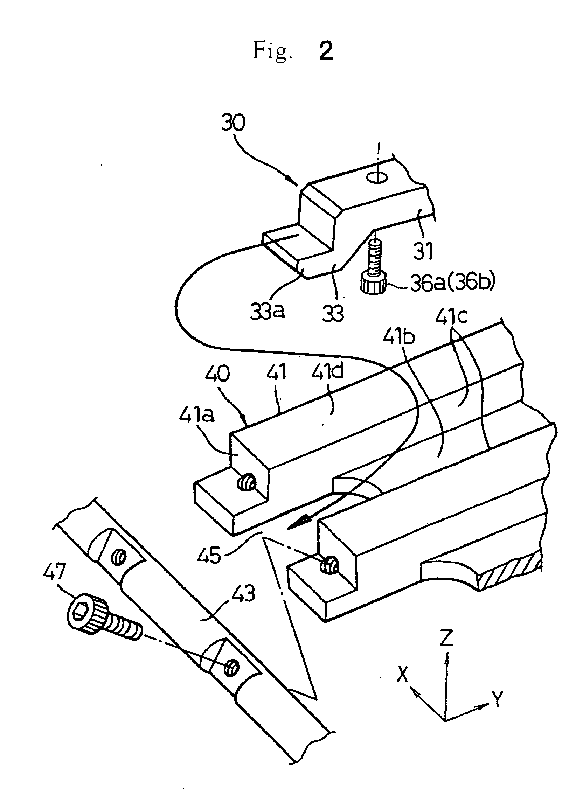

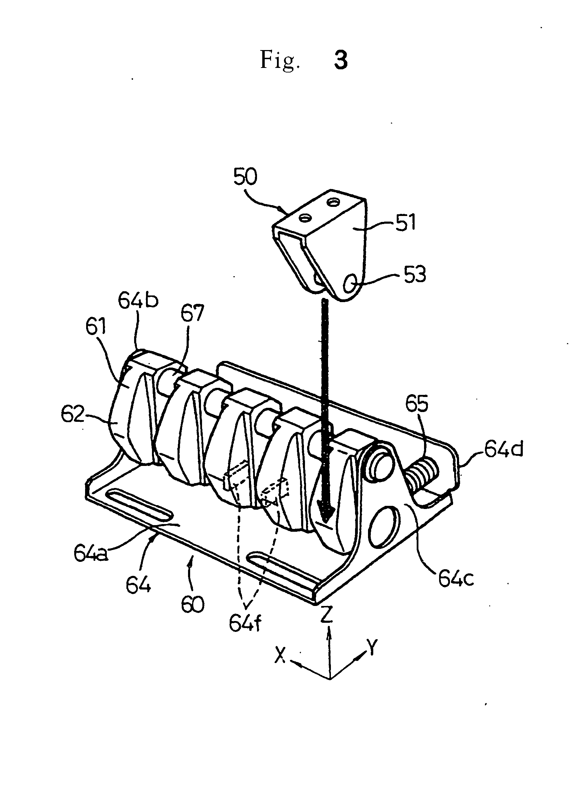

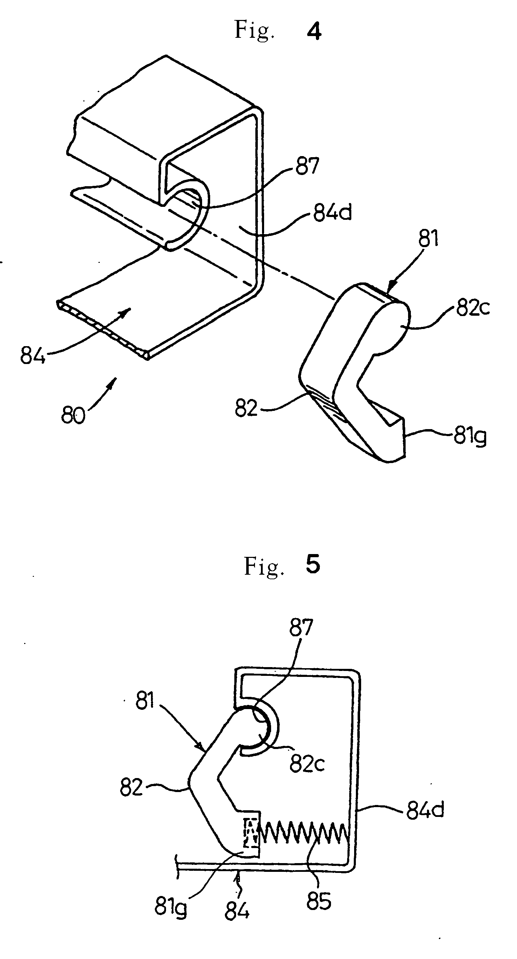

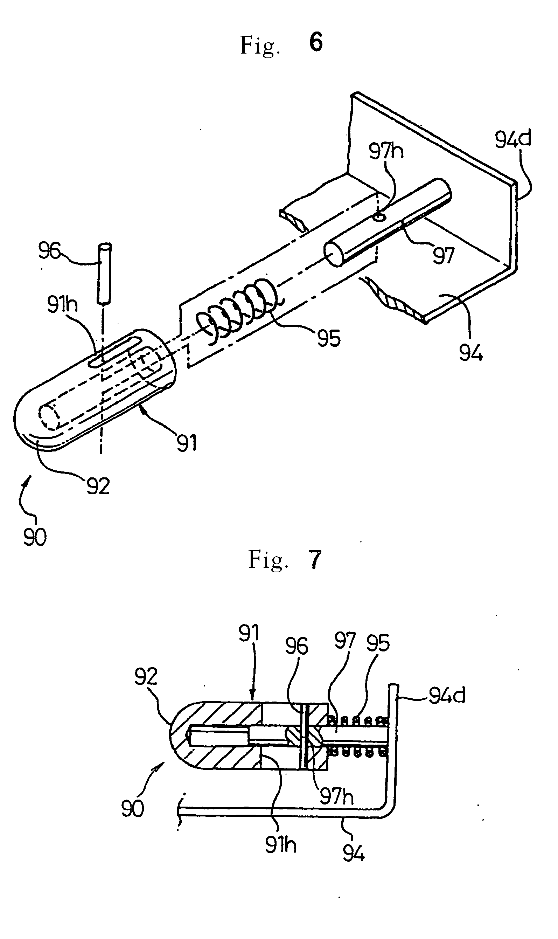

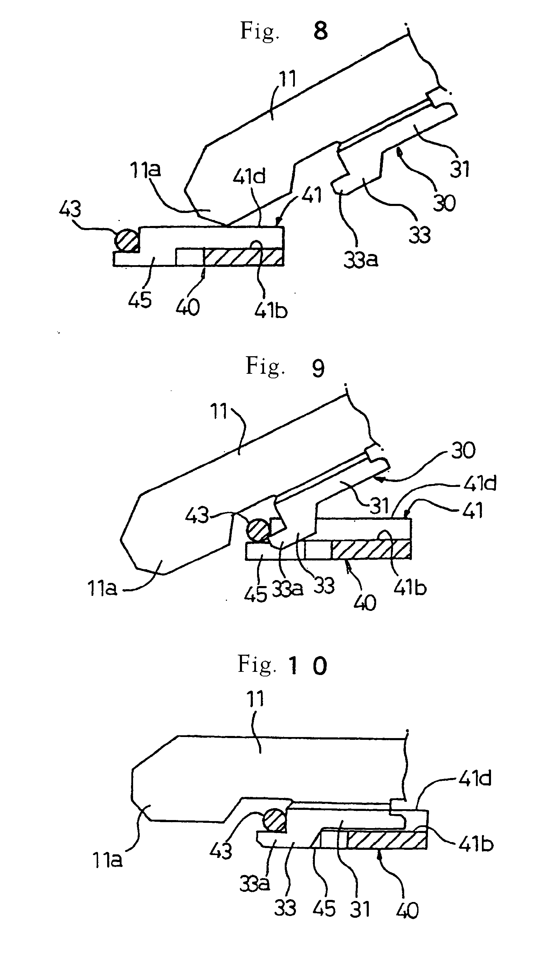

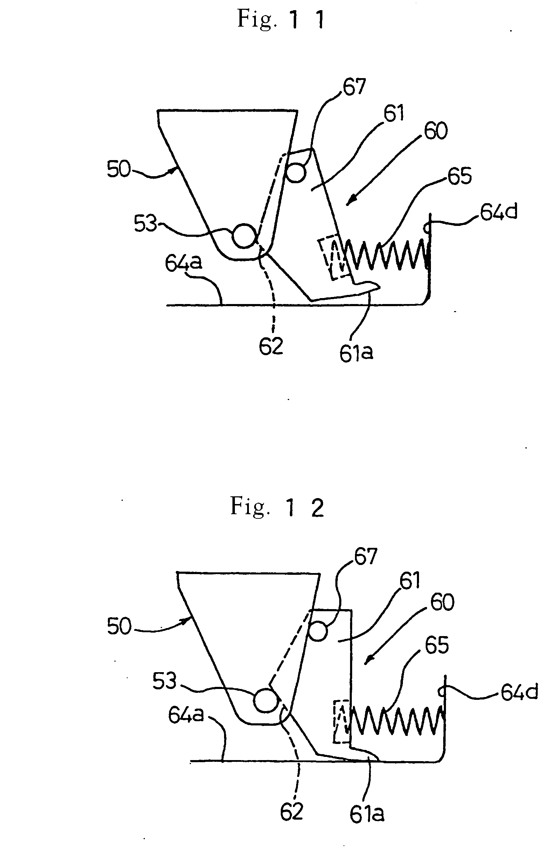

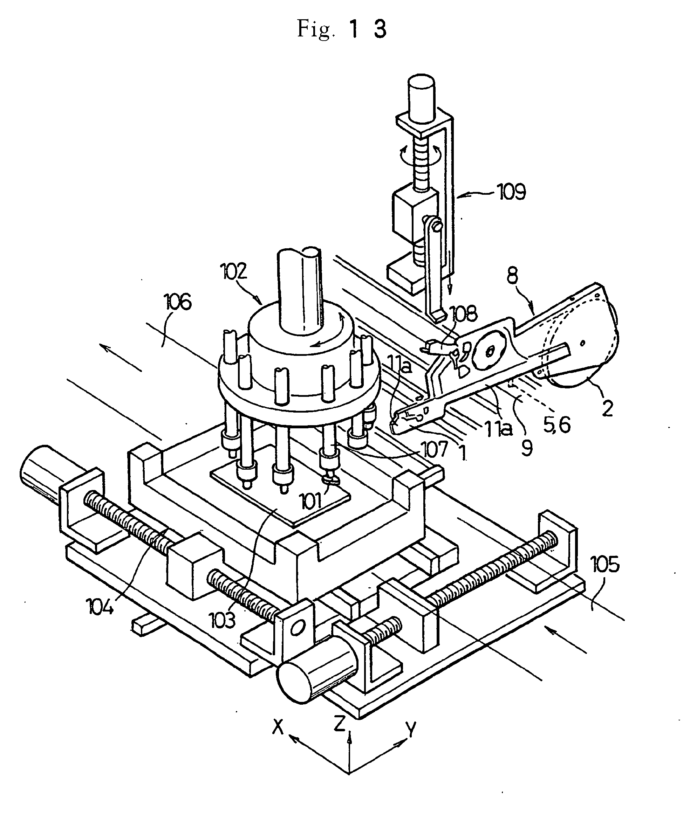

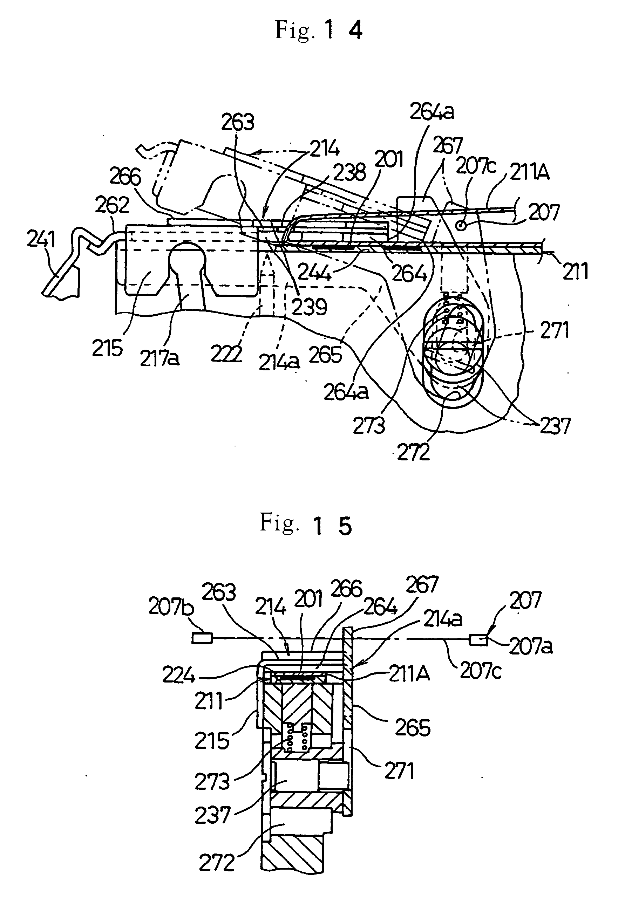

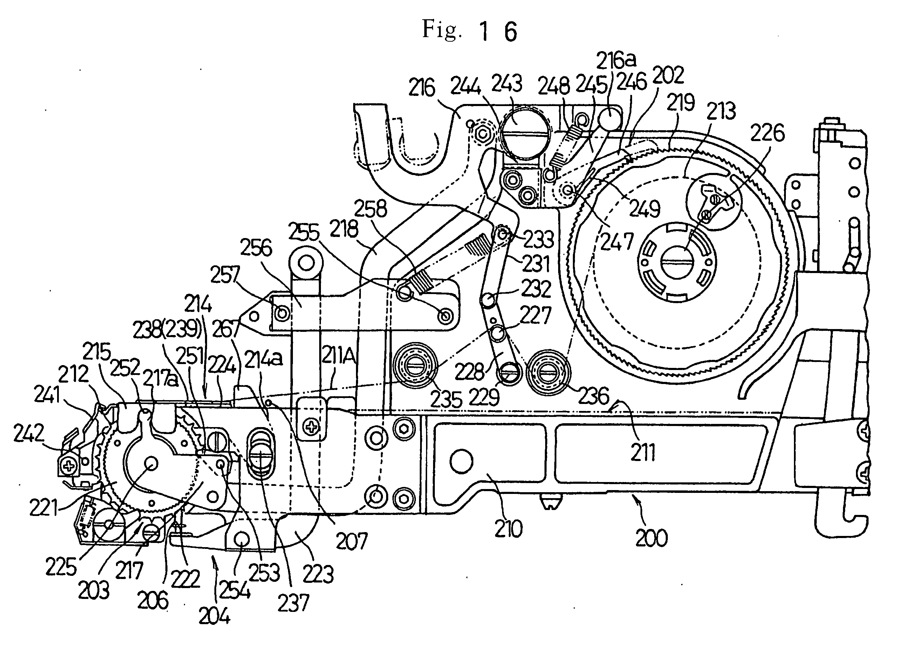

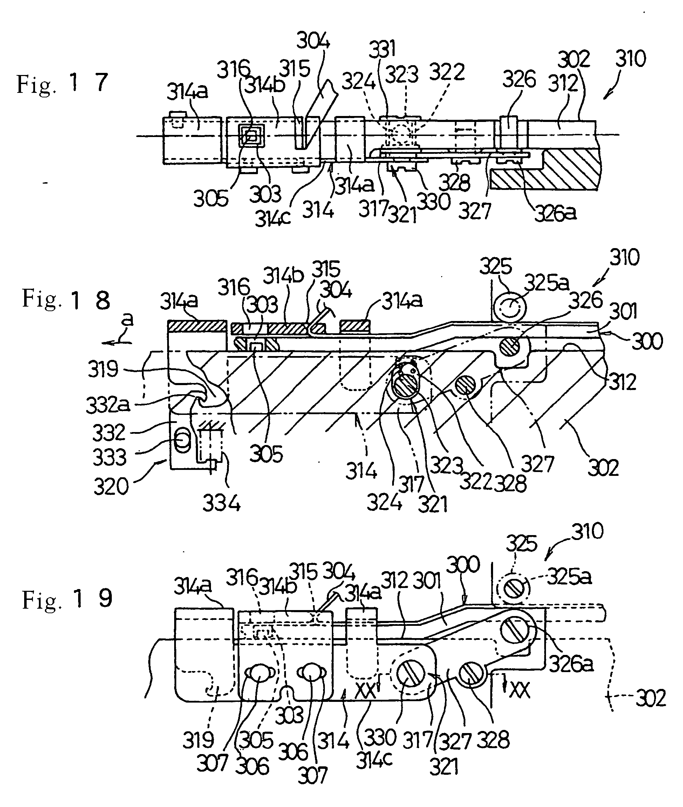

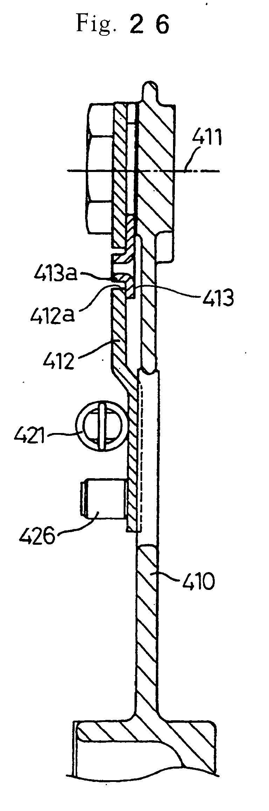

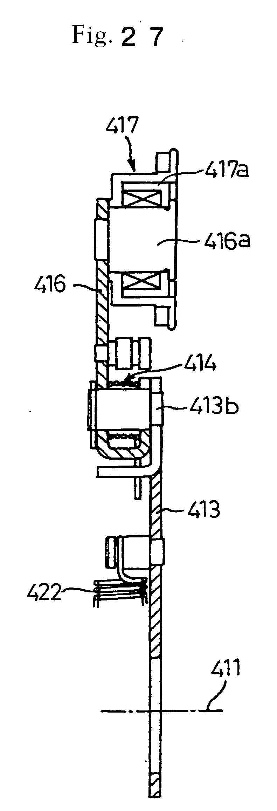

Hereinafter, for the sake of understanding the present invention, several embodiments most preferable to attain the main object of the present invention while solving individual problems described above will be described with reference with Fig. 1 to Fig. 50.

### (First Embodiment)

A first embodiment of the present invention is an example of fabricating an electronic circuit board by supplying an electronic component 101 using a cassette-type component feeding device 8 in an electronic-component mounting apparatus as shown in Fig. 13. The component feeding device 8 has a basic structure in common with one described in the conventional example. The electronic component 101 fed from the component feeding device 8 is sucked and held on a mounting head 102 and is then mounted on a circuit board 103, thereby fabricating an electronic circuit board. A number of component feeding devices 8 are mounted on the components feeding table 7 in line in the left and right moving direction, i.e., in the direction of the arrow x to conveniently feed an electronic component 101 from the component-supplying device 8 having the electronic component 101 required at any given time by moving the components feeding table 7 in the X direction. The circuit board 103 is positioned in a right place in two directions of X and Y perpendicular to each other by an XY table 104, so that the electronic component 101 to be fed can be mounted on a required position. The XY table 104 repeats the steps of receiving a circuit board 103 through a loading portion 105, mounting the electronic component 101 thereon, and then discharging it through an unloading portion 106. The mounting head 102 has a number of suction nozzles 107 on the same circle and repeats the steps of holding the electronic component 100, which can be fed by the component feeding device 8 every time a push-down mechanism 109 pushes a feed lever 102 down, by suction through a suction nozzle 107 to pick up and bring the electronic component 101 and mounting the electronic component 101 on the circuit board 103.

The first embodiment of the present invention attains the above object by the features of the method and mechanism in which the component feeding device 8 is mounted on the components feeding table 7. In Fig. 1 and Fig. 13, the main body 11 of the component feeding device 8 has a front end portion 11a on which an intermittent driving mechanism (not shown) for pitch-feeding the tape-shaped holder and a rear end on which a winding reel 2 with the taping component can be attached and detached. In the forward and backward directions of the main body 11, i.e., in the Y direction, there is provided a setting portion 21 facing to the components feeding table 7 is provided on the bottom surface of the middle portion.

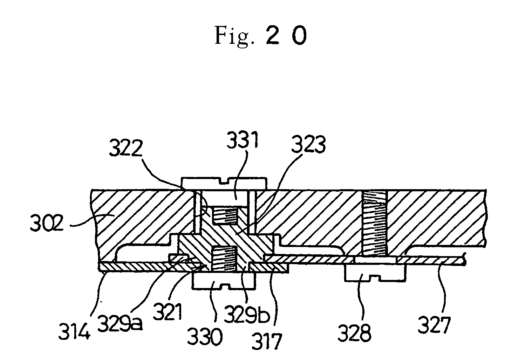

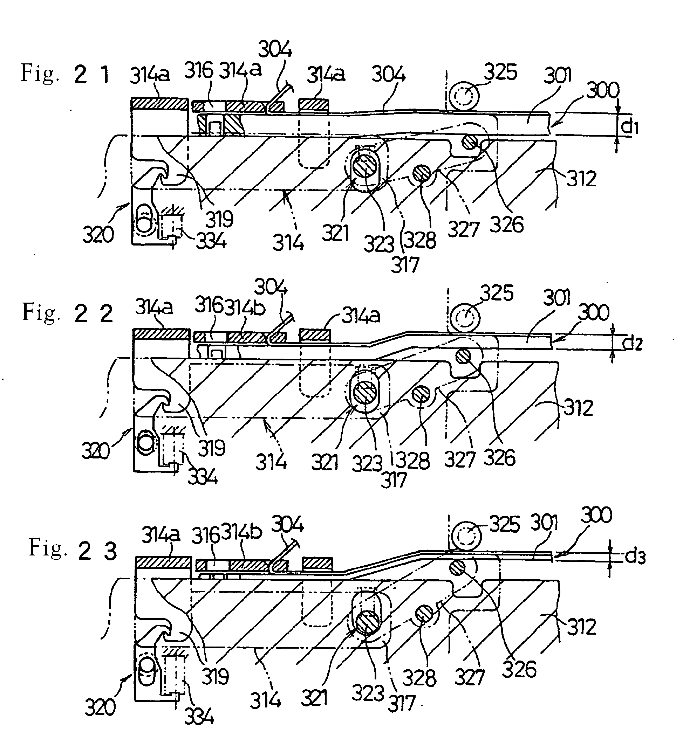

First engaging means 30 is provided on the front end side of the setting portion 21 of the component feeding device 8. On the components feeding table 7 opposite to the first engaging means 30, first retaining means 40 which can be engaged with the first engaging means 30 is arranged. As illustrated in Fig. 2 in detail, the first engaging means comprises a body portion 31 to be attached on the main body 11 of the component feeding device 8 using bolts 36a, 36b (see Fig. 1), and a hooked portion 33 having a hook 33a in the downward direction, which is integrally formed on the front end of the body portion 31.

On the other hand, the first retaining means 40 comprises a holding portion 41 to be attached on a hollow portion 7a (see Fig. 1) of the components feeding table 7 using bolts (not shown) and a generally column shaped retaining rod 43 which can be fixed on a front end notch 41a of the above holding portion 41 using bolts 47 and can be also engaged with the hook 33a of the above hooked portion 33.

The holding portion 41 of the above first retaining means 40 comprises: a groove 41b for receiving the above hooked portion 33 and allowing the hooked portion 33 to engage with the retaining rod 43; and an opening 45 formed by cutting the front end thereof for allowing the hooked portion 33 to be housed in the opening 45. In addition, the both side surfaces 41c of the above grooved portion 41b are defined to have their own widths allowing the body portion 31 of the first engaging means 30 to be positioned precisely in the X direction. Furthermore, as described above, the retaining rod 43 is fixed in the front end notched portion 41a of the holding portion 41 using bolts 47 tilted at an angle of about 45 degrees such that the upper surface of the retaining rod 43 is substantially arranged at the same height as the upper surface 41d of the holding portion 41. In addition, the bottom surface of the retaining rod 43 and the upper surface of the hook 33a of the hooked portion 33 are engaged with each other at a position lower than the upper surface 41d of the holding portion 41. In other words, the first retaining means 40 which does not extend above the upper surface of the holding portion 14 is engaged with the first engaging means 30 at a defined engaging position lower than the upper surface 41d of the holding portion 14. Thus, the first engaging means 30 is arranged and fixed in the right place together with the component feeding device 8 in the vertical direction with respect to the first retaining means 40, i.e., in the Z direction as well as in the X direction.

As shown in Fig. 1, second engaging means 50 is provided on the rear end side of the setting portion 21 of the component feeding device 8. On the components feeding table 7 opposite to the second engaging means 50, there is arranged second retaining means 60 which can be engaged with the second engaging means 50. As illustrated in Fig. 3 in detail, the second engaging means 50 comprises a bracket 51 in the shape of substantially the letter C in the side view, which can be attached on the body 11 of the component feeding device 8 using bolts 3a, 3b (Fig. 1), and an engaging shaft 53 which is a shaft core provided in the direction perpendicular to the above bracket 51.

On the other hand, the above second retaining means 60 comprises: an oscillation member 61 provided as a retaining member to be oscillated in the forward and backward directions, on which an engaging protrusion 62 for engaging with the engaging shaft 53 of the above second engaging means 50 is formed; a turning shaft 67 axially supporting the above oscillation member 61 so that it can be oscillated back and forth in the Y direction; a supporting member 64 for supporting the above turning shaft 67, which is fixed on the components feeding table 7 using bolts 4a, 4b (Fig. 1); and a helical compression spring 65 provided between the rear end of the above oscillation member 61 and the rear end wall 64d of the above supporting member 64 and provided as energization means for strongly energizing the oscillation member 61 to keep the position thereof being forwardly oscillated to retain the engaging shaft 53, while allowing it to be shifted to the position being backwardly oscillated, where the engaging protrusion 62 of the oscillation member receives the engaging shaft 53.

The above oscillation member 61 is made of a resin for example, and a tip portion thereof is in the shape of substantially the letter C in the front view and constitutes the engaging protrusion 62 that engages with the engaging shaft 53 to hold it. A plurality of (five in the figure) the oscillation members 61 have their respective upper portions supported by a single shaft 67 made of metal extended in the X direction such that they can be freely oscillated. That is, the turning shaft 67 is not provided for each oscillation member 61, but a plurality of oscillation members 61 are designed to share the shaft 67. By the way, for obtaining a good sliding ability with the shaft 67 and the reliable engagement with the engaging shaft 53, it is preferable that the oscillation member 61 be made of a resin with a good sliding ability and a sufficient strength. However, this arrangement is suited for a case of the supporting structure where the shaft 67 cannot be turned.

The supporting member 64 for supporting this shaft 67 comprises: a base 64a which is a portion fixed on the components feeding table 7 using bolts (not shown); side walls 64b, 64c that are vertically provided on both ends of the base 64a in the X direction in Fig. 3 and support both end portions of the above turning shaft 67; positioning walls 64f vertically provided on the base 64a as well as the side walls 64b, 64c for positioning the oscillation member 61 in the right and left directions by restricting the position of both side surfaces of the lower end portion of each of five oscillation members 61 (in the figure, the positioning walls corresponding to the third oscillation member from the left and right of five oscillation members 61 are only illustrated as representative examples by means of dashed lines); and the rear end wall 64d vertically provided on the rear end of the base 64a. The lower end 61a of the oscillation member 61 (see Fig. 1) is stopped by touching on the base 64a.

There are five portions (protruded toward the oscillation member 61) (not shown) subjected to the drawing process are formed on the rear end wall 64d of the supporting member 64. Each of the drawn portions forms a retaining portion that supports one end of the helical compression spring 65. On the other hand, the other end of the helical compression spring 65 is retained in a hollow portion formed in the rear end of the above oscillation member 61. By the way, it is possible to utilize energization means such a blade spring or a rubber instead of using the helical compression spring 65 as far as an appropriate energization force is obtained. The second retaining means 60 described above is simply constructed of: the oscillation members 61, the turning shaft 67 capable of supporting a plurality of the oscillation members 61, the supporting member 64 also capable of installing a plurality of the oscillation members 61, and helical compression springs 65. Therefore, the number of components is small, so that it can be fabricated at a low price.

By the way, the above second retaining means may be shaped as illustrated in Fig. 4 and Fig. 5. That is, the second retaining means 80 shown in Fig. 4 and Fig. 5 comprises: an oscillation member 81 provided as a retaining member capable of oscillating forward and backward, on which an engaging protrusion 82 is formed and is engaged with an engaging shaft 53 of the second engaging means 50; a supporting member 84 fabricated by aluminum drawing process or the like, on which a C-shaped portion 87 for supporting an cylindrical portion 82c of the upper end of the above oscillation member 81; and a helical compression spring 85 inserted between the lower end 81g of the above oscillation member 81 and the rear end wall 84d of the above supporting member 84 and provided as energization means that strongly energize the oscillation member 81 in a forward-looking oscillation position for retaining the engaging shaft 83 while it is allowed to shift into a backward-looking oscillation position by which the engaging protrusion 82 receives the engaging shaft 53 of the oscillation member 81. By the way, other components are substantially similar to those of the above second retaining means 60.

Furthermore, the above second retaining means may be shaped as illustrated in Fig. 6 and Fig. 7. That is, the second retaining means 90 shown in Fig. 6 and Fig. 7 comprises: a linear motion member 91 provided as a retaining member capable of forward and backward linear motions, on which an engaging protrusion 92 to be engaged with the engaging shaft 53 of the above second engaging means 50 is formed; a supporting pin 97 that guides the linear motion of the above linear motion member 91; a supporting member 94 having a rear end wall 94d on which the supporting pin 97 is vertically provided; a helical compression spring 95 provided as energization means that strongly energizes the linear motion member 91 at a forward-looking shifted position where the engaging shaft 53 is retained while the linear motion member 91 can be moved toward a backward-looking shifted position where the engaging protrusion 92 of the linear motion member 91 receives the engaging shaft 53, which is inserted between the rear end of the above linear motion member 91 and the rear end wall 94d of the above supporting member 94 and is wound around the above pin 97; and a regulation pin 96 vertically inserted through a central hole 97h of the above supporting pin 97 and fixed thereon such that the forward and backward strokes of the above linear motion member 91 is restricted by engaging with a hole 91h of the above linear motion member 91. By the way, other components are substantially similar to those of the above second retaining means 60.

Furthermore, as shown in Fig. 13, the regulation pin 5 is hanged down on the rear end side of the setting portion 21 of the component feeding device 8 backward from the second engaging means 50. On the components feeding table 7, there is provided a flat portion for positioning in the Z and X directions, which regulates the height position of the flat portion on the rear end side continuously extending to a hole 6 for housing the regulation pin and the setting portion 21.

Next, the process for mounting the component feeding device 8 on the components feeding table 7 will be described with reference to Fig. 8 to Fig. 12.

At first, as shown in Fig. 8, the front end portion 11a of the component feeding device 8 is tilted downward and is then shifted forward on the feeding table 7 and continuously on the holding portion 41 of the first retaining member 40. Subsequently, as shown in Fig. 9, the hooked portion 33 of the first engaging means 30 is fitted into the groove 41b of the first retaining means 40 to arrange it in the right place in the X direction, while inserting into the opening 45 formed in the front end portion of the groove 41b. After that, as shown in Fig. 10, the upper surface of the hook 33 of the hooked portion 33 is engaged with the lower surface of the retaining rod 43 to move the rear portion of the component feeding device 8 down to fit the regulation pin 5 into the pore 6 and put it on the flat portion 39 while restricting it in the predetermined height position. Here, even though the front end portion 11a of the component feeding device 8 is tilted downward and is then shifted forward on the feeding table 7 and the holding portion 41 of the first retaining means 40, a portion of the first retaining means 40 to be engaged with the hooked portion 33 of the first engaging means 30 does not include a protruded portion extending upward from the upper surface 41d of the holding portion 41. Therefore, there is no obstacle at the time of such a movement and the front end portion 11a of the component feeding device is prevented from being damaged.

The relation between the second engaging means 50 and the second retaining means 60 at the time of arriving at the position shown in Fig. 10 is illustrated in Fig. 11 and Fig. 12. As shown in Fig. 11, when the engaging shaft 53 of the second engaging means 50 touches on the engaging protrusion 62 of the oscillation member 61, the oscillation member 61 oscillates backward and around the turning shaft 67 counterclockwise under the condition in which the oscillation member 61 is pushed back against the energization of the helical compression spring 65 to receive the engaging shaft 53 under the engaging protrusion 62. After that, as shown in Fig. 12, when the engaging shaft 53 of the second engaging means 50 is moved over the engaging protrusion 62 of the oscillation member 61, the oscillation member 61 is returned by oscillating forward and clockwise with the energization force of the helical compression spring 65. The engaging shaft 53 of the second engaging means 50 is retained such that it cannot be moved up from its position. Thus, the component feeding device 8 is arranged in the right place in both of the Z and X directions and is then fixed on the components feeding table 7. By the way, in a retaining state of the above engaging shaft 53, the supporting member 64 of the lower end 61a touches on the base 64a, so that the oscillation member 61 can be prevented from being more oscillated forward by the energization force of the above helical compression spring 65.

Here, when the engaging shaft 53 of the second retaining means 50 is removed from the oscillation member 61 of the above second retaining means 60, the oscillation member 61 is automatically returned by the energization of the helical compression spring 65, resulting in a ready condition. Thus, the second retaining means is not in an operation-disabled condition without discretion.

As described above, the component feeding device 8 can be arranged and fixed in the right place on the components feeding table 7 by one-touch control.

By the way, the present invention is not limited to the embodiment described above, in addition to the shape of the retaining rod of the first retaining means, the shape of the engaging shaft of the second engaging means, and the shape of the oscillation member, it is evident that the engagements with the first retaining means, the first engaging means of the second retaining means, and the second engaging means, their operation methods, and so on can be appropriately modified.

### (Second Embodiment)

A second embodiment of the present invention, in a component feeding device 200 shown in Fig. 16, attains the main object of the present invention by solving individual problems described above with respect to the tape presser which has been conventionally used for preventing an electronic component 201 from being brought out and for stabilization with pressing a taping component 211 at the time of feeding the electronic component 201 accommodated in the taping component 211 as shown in Fig. 14 and Fig. 15.

The component feeding device 200 shown in Fig. 16 in accordance with the second embodiment of the present invention incorporates in the device main body 210: a sprocket wheel 212 that performs the pitch-feed of a taping component 211; a cover-tap winding-up mechanism 202 including a winding reel 213 for winding up a cover tape 211A of the taping component 211; an intermittent driving mechanism 203 having a feed lever 216, levers 217-218, claw wheels 219, 221, and so on, which is provided for intermittently moving the tape presser 214 including an arm 214a and a shutter 215 and the taping component 211, opening the shutter 215 of the tape presser 214, and synchronously revolving the winding reel 213; and a push-out mechanism 204 including a push rod 222 and a lever 223 for pushing an electronic component 201 from the carrier tape 211B of the taping component 211.

The taping component 211 is of a well-known configuration comprised of the carrier tape 211B that holds the electronic component 201 and the cover tape 211A layered on the carrier tape 211B in a peelable manner. In the side edges, feed holes are formed at regular intervals in the longitudinal direction. The electronic component 201 is accommodated in a hollow portion formed in the carrier tape 211B and is then sealed with the cover tape 211A.

As shown in Fig. 16, the sprocket wheel 212 has claws on its peripheral surface, which can be engaged with the feed holes of the taping component 211. The claws are protruded on a tape guide 224 formed on the upper portion of the device main body 210 so as to be held on the device main body 210 through the shaft 226 in a rotatable manner.

The winding reel 213 is held on the device main body 210 through the shaft 225 in a rotatable manner. Between the tape presser 214 and the cover-tape winding mechanism 202 provided is a change roller 227 for the cover tape 211A which is peeled off from the carrier tape 211B at the tape presser 214 and is then wound on the pull-out cover-tape winding mechanism 202, and the change roller 227 is held on a lever 228. One end of the lever 228 is connected to the device main body 210 through a pin 229, while the other end thereof is connected to one end of an arm 231 through a pin 232. The lever 231 is connected to the above feed lever 216 through a pin 232. On the both sides of the charge roller 227, guide rollers 235, 236 are located and are attached on the device main body 210 through their shafts in a rotatable manner.

The tape presser 214 is attached on the device main body 210 such that the arm 214a is allowed to turn around a pin 237 shown in Figs. 14 to 16. The shutter 215 is, as will be described latter in detail, attached on the arm 214a such that it can be slid on the arm 214a vertically. The arm 124a and the shutter 215 have slits 238 and notches 239 as shown in Fig. 14 in their upper surface walls through which the cover tape 211A of the taping component 211 can be passed. The notch 239 of the arm 214a is also used for pulling out and picking up the electronic component 201 accommodated in the carrier tape 211B. By the way, the notch or alternatively a window may be formed in addition to the slit for pulling the cover tape 211A out. A latch arm 241 is provided such that it is supported on the device main body 210 through a shaft 242 as shown in Fig. 16 and is opposite to the tip of the above arm 214a as shown in Fig. 14 and Fig. 15. As shown in Fig. 14 and Fig. 16, the latch arm 241 can be turned between an operative position where it is engaged with the tip of the arm 214a and a release position where it is detached from the tip.

In Fig. 16, the rotation of the winding reel 213 and the rotation of the sprocket wheel 212 in the cover-tape winding mechanism 202 are synchronized with a sliding movement of the shutter 215 at the tape presser 214. The winding reel 213 and the sprocket wheel 212 are revolved by means of the feed lever 216, the levers 217-218, and the claw wheels 219 and 221. The claw wheel 219 is co-axially supported on the shaft 226 in a rotatable manner. The feed lever 216 is supported by the shaft 243 in the device main body 210 so as to be independently revolved together with the lever 224 on the base side of a series of the connection levers 244, 245 connected to each other. There is a helical extension spring 248 between the connection levers 244, 245 and the feed lever 216. The lever 245 on the tip side of the connection levers 244, 245 touches on a stopper pin 216a provided on the tail end of the feed lever 216. The connection levers 244, 245 follow the turning of the feed lever 216 as far as the external force of above the predetermined level is not exerted. On the tip side of the feed lever 216, the base of a claw 246 is supported such that it can be revolved with a pin 247. Between the claw 246 and the connection levers 244, 245, there is a helical torsion coil spring 249 that can be brought into action around the pin 247 for allowing the tip of the claw 246 to engage with the claw wheel 219.

The claw wheel 221 in the intermittent driving mechanism 202 is fitted into the shaft 225 of the sprocket wheel 212 and is fixed therein, so that it can be integrally rotated with the sprocket wheel 212. The above lever 217 shares the shaft 225 and is supported thereon so as to be able to turn around and the base of a claw 251 for the pitch-feed is supported on its tip in a rotatable manner using a pin 253, so that the claw 251 can be engaged with the claw wheel 221 by an energization of a helical torsion coil spring (not shown) exerted between the lever 217 and the claw 251. The lever 217 is connected to the feed lever 216 through the above lever 218.

As constructed above, at the time of feeding components, when the feed lever 216 is pushed down against the energization of the coil spring 258 exerted thereon for the returning movement and rotates counterclockwise, the claw wheel 219 is rotated by the claw 246 in the cover-tape winding mechanism 202 to allow the winding reel 213 to integrally rotate in the winding direction, so that the cover tape 211A can be wound on the winding reel 213. Simultaneously, the lever 218 moves downward to turn the lever 217 clockwise in the intermittent driving mechanism 203, so that the claw 251 moves downward while sliding on the claw wheel 221. Then, the lever 217 allows the shutter 215 to move backward in the right direction in Fig. 16 by engaging the arm 217a provided on a part of the lever 217 with a notch 252 of the shutter 215. At this time, the shutter 215 is opened and is accommodated in the carrier tape 211B of the taping component 211, so that the electronic component 201 exposed by the peeling-off of the cover tape 211A can be provided for the pick up from the outside. On the other hand, the charge roller 227 is oscillated backward through the levers 231, 228 by pushing the feed lever 216 down to pull the cover tape 211A, contributing to the peeling-off of the cover tape 211A from the carrier tape 211B and the winding around the winding reel 213.

When the feed lever 216 is freed from being pushed down and is then turned clockwise as a returning movement by the energization of the coil spring 258, the claw 246 slides on the claw wheel 219 in the cover-tape winding mechanism 202, while returning to its initial position without allowing the claw wheel 219 and the winding reel 213 to turn in the reverse direction. In practice, a hold-back claw (not shown) works. Simultaneously, the lever 218 moves upward to return. In addition, the lever 217 turns counterclockwise as a returning movement in the intermittent driving mechanism. The claw 251 allows the claw wheel 221 to turn counterclockwise together with the sprocket wheel 212 to pitch-feed the taping component 211, while closing the shutter 215 by moving forward in a direction opposite to one described above. Therefore, the electronic component 201 transferred to the predetermined position can be prevented from rotating or flying out by the peeling-off of the cover tape 211A.

The push rod 222 in the push-out mechanism 204 is supported on the device main body 210 such that it moves between a position from which its upper end is protruded from the tape guide 224 and a position where it is brought, and is also pushed down by the coil spring 206 arranged between the device main body 210 and the push rod 222 for always keeping it at the bring-in position. The lower end portion of the above lever 223 is opposite to the lower end of the above push rod 222 from the downward direction and is supported on the device main body 210 through the shaft 254 in a rotatable manner at a position near the simplified portion. On the other hand, a lever 256 is provided on the device main body 210 such that its base is supported through the shaft 255 in a rotatable manner and its tip extends forward to a position in front of the upper end of the lever 223. A pin 257 provided on the tip of the lever 256 is arranged such that it hooks on the upper end of the above lever 223 from the front side. Such a hooked condition can be kept by the energization of the returning spring 258 exerted between the levers 223, 256. When the feed lever 216 is located at returning movement position, the lever 223 touches on the lower end of the push rod 222 at the above moving-downward position through the lever 256. Therefore, the feed lever 216 is pushed down and is rotated counterclockwise to wind up the cover tape 211A, and together with the backward movement of the shutter 215, the lever 223 can be turned clockwise through the pin 257 by turning the lever 256 clockwise through the coil spring 258. As a result of such a turning movement, the lever 223 allows the push rod 222 to move upward against the energization of the coil spring 206. Then, the above shutter 215 is opened to push the electronic component 201 to be picked up upward, so that the electronic component 201 can be easily pushed out for a predetermined distance and easily picked up from the carrier tape 211B. When the feed lever 216 performs its returning movement with the energization of the coil spring 258, the push-out mechanism 204 is also returned to its initial state with the energization of the coil springs 206, 258.

Here, the following will describe the procedures for attaching the taping component 211. In the device main body 210, the arm 214a and the shutter 215, i.e., the tape presser 214 is turned counterclockwise around the pin 237 and is then shifted to the release position escaped upward from the tape guide 224. The taping component 211 is moved along the tape guide 224 to fit the perforations of the taping component 211 with the sprocket wheel 212, while the cover tape 211A is passed through the notch 239 of the arm 214a and the slit 238 of the shutter 215, followed by inverting at an angle of about 180 degrees. Then, it passes through the guide roller 235, the tension roller 227 and the guide roller 236 and is then wound on the winding reel 213, followed by returning the tape presser 24 to the operative position along the tape guide 224 as illustrated by a solid line in Fig. 14 to bring the taping component 211 to a state of being pressed. Then, the latch arm 241 is engaged with the tip of the arm 214a of the tape presser 214 and the tape presser 214 is locked in the tape-pressing state to complete the attachment.

In the second embodiment of the present invention, at this time, if the tape presser 214 is not reliably locked by an operator, the taping component 211 is not completely attached, or the arm 214a is released from the latch arm 241, it can be positively distinguished.

For the explanation thereof, the tape presser 214 comprises the arm 214a in the shape of substantially the letter L in cross section as shown in Fig. 15, and the shutter 215. The upper surface wall of the arm 214a is notched except portions 262, 264. In addition, a notch 239 is formed in the upper wall portion 263 of the shutter 215, through which the cover tape 211A of the taping component 211 can be passed. The side surface wall 265 of the arm 214a is shaped like the letter T substantially laterally lying down while directing its head backward. A portion of the upper edge of the side surface wall 265, which corresponds to the foot area of the letter T, is bent at a right angle so as to be horizontally directed in parallel to the tape guide 224, forming a shutter guide 266 for guiding the back and forth movements of the shutter 215. A portion 267 of the side surface wall 265, which is directed upward and corresponds to the head of the letter T, protrudes upwardly from the upper surface walls 262, 264 and is provided as a to-be-detected portion 267 for automatically detecting the floating of the tape presser 214 from the fixed side, for example from the electronic-component mounting apparatus.

The shutter 215 has the above slit 238 on its upper surface wall 268, through which the cover tape 211A of the taping component 211 can be passed, while the above notch 252 engaging with the above arm 217a is formed in the side surface wall 269. This shutter 215 is inserted into a space formed by the upper surface wall portions 262, 264 and the shutter guide 266 by making a contact between the upper surface wall 268 and the upper surface wall portions 262, 264 of the arm 214a, so that the shutter 215 can be slid on the arm 214a between a position where the notch 239 of the arm 214a is closed and a position where the notch is opened.

The tape presser 214 provided as an assembly of the arm 214a and the shutter 215 is supported on the device main body 210 so as to be moved vertically by means of the pin 237 provided as a center of the rotation. The pin 237 is fitted in a long hole 272 formed in the device main body 210 for the vertical movement such that the pin 237 can be moved up and down. On the other hand, the arm 214a is fitted with the above pin 237 through a long hole 271 formed in the side surface wall 265 such that it can be moved up and down in addition to turn around the pin 237. Therefore, the tape presser 214 can be moved up and down on the device main body 210 together with the pin 237 and can be moved up and down on the pin 237, and also it can be turned on the pin 237. In the long hole 272 of the device main body 210, a helical compression spring 273 is worked between a convex spring washer in the member 274 screwed in the device main body 210 and a concave spring washer on the peripheral surface of the pin 237 such that the pin 247 is energized toward the lower side of the long hole 272. The supporting position of the arm 214a with the pin 247 is defined so as to be located in the rear of the upper surface wall 264, while the tape presser 214 is oriented as illustrated by a solid line in Fig. 14 to press the taping component 211, i.e., the upper surface wall 264 is horizontally oriented in parallel to the taping component 211 or the tape guide 224.

When this kind of the tape presser 214 is inclined toward the taping component 211 at the time of pressing the taping component 211, in other words, when the tape presser 214 is moved from a release position indicated by a chain double-dashed line to an operative position indicated by a solid line in Fig. 14, the tape presser 214 turns counterclockwise around the pin 237 and lifts the pin 237, while the rear-end lower angled portion 264a of the upper surface wall portion 264 of the arm 214a turns counterclockwise around a portion touched with the tape guide 224 in the device main body 210. The arm 214a of the tape presser 214 and the shutter 215 are inclined so as to be substantially in parallel to the taping component 211 while touching the taping component 211 as indicated by a solid line in Fig. 14, resulting in the operative position where it is pressed. At this time, the tape presser 214 compresses the helical compression spring 273 by lifting the pin 237 in the long hole 272, while the contacting point between the rear-end lower angled portion 264a of the above upper surface wall portion 264 and the taping component 211 is shifted forward to the position indicated by a solid line in Fig. 14.

When the tape presser 214 is located at the operative position indicated by a solid line in Fig. 14 where the taping component 211 is pressed, the amount of backward displacement with respect to the upper surface wall portion 264 of the arm 214a of the pin 237 becomes larger than one in a state represented by a phantom line in Fig. 14 and the helical compression spring 273 is charged by compression from the time of the state of the phantom line. Therefore, the helical compression spring 273 pushes the pin 237 down in the long hole 272. Simultaneously, it powerfully acts such that the tape presser 214 at the operative position indicated by a solid line in Fig. 14 is turned clockwise around the portion where the rear end angled portion 264a of the upper surface wall portion 264 touches on the taping component 211 and is risen to move backward so as to be returned to the releasing position indicated by a phantom line in Fig. 14.

Then, when the tape presser 214 is located on the operative position indicated by a solid line in Fig. 14, the tape presser 214 is retained at the operative position so as to be stabilized by engaging the latch arm 241 with the tip of the arm 214a of the tape presser 214. If any problem is found in the attachment of the taping component 211, the tape presser 214 cannot be retained at the operative position with the latch arm 241, or imperfectly retained. Thus, the tape presser 214 is automatically lifted to the release position indicated by a chain double-dashed line in Fig. 14 by energization of the above helical compression spring 273. Therefore, when the component feeding device 200 on which the taping component 211 is set is mounted on the components feeding table 7 or the like of the electronic-component mounting apparatus in Fig. 13 referenced in the description about the first embodiment to feed the electronic component 201, the tape presser 214 may be lifted to the release position, which can be highly visible and can be easily discovered by visual inspection when the highly visible position is defined as a release position. Therefore, it becomes possible to prevent the component feeding device 200 on which the tape presser 214 is lifted from being mounted and used in advance, permitting quick action.

Consequently, in the component feeding device 200 to be mounted and used in the electronic-component mounting apparatus, the problems that the tape presser 214 is lifted and the taping component 211 is then lifted and the electronic component 201 is turned or detached by vibration are solved. In addition, there is no mistake in the feed of the electronic component 201 and no trouble therein, so that any time loss caused by feeding or mounting the electronic component 201 again cannot be observed and the decrease in the yields of the electronic component 201 and the product can be avoided. Furthermore, it can be avoided that the lifted tape presser 214 is interfered with other components such as those on the electronic-component mounting apparatus side to cause any damage with each other by the movement of the components feeding table 7. Therefore, any time loss to be caused by repair work on such a damage and the replacement of a damaged portion in the electronic-component mounting apparatus or the damaged component feeding device 200 with new one cannot be generated. In the unlikely event that any trouble of lifting the tape presser 214 caused by poor setting of the taping component 211, poor retaining of the tape presser 214 with the latch arm 241, or the like is caused in any component feeding device 200 mounted on the components feeding table 7, the troubled component feeding device 200 can be visually detected and addressed at an early stage as the tape presser 214 can be automatically lifted as described above. Therefore, the time loss to be caused by such an event can be suppressed to the minimum.

Furthermore, the tape presser 214 has a moving stroke enough to avoid that the to-be-detected portions 267 formed on the arm 214a is not overlapped one another between the operative position and the release position respectively represented by a solid line and a chain double-dashed line in Fig. 14. Therefore, the lifting of the tape presser 214 in the component feeding device 200 mounted on the components feeding table 7 can be automatically detected with the detecting means on the fixed side of the electronic-component mounting apparatus or the like by detecting which position the to-be-detected portion 267 is located with a photo coupler 207 shown in Figs. 14 to 16. In Fig. 14 and Fig. 15, the photo coupler 207 is used as detecting means and corresponds to the to-be-detected portion 267 at the release position where a detecting optical path 207c between a projector 207a and a photoreceptor 207b of the photo coupler 207 is lifted. The lifting, i.e., the operative position can be detected as the to-be-detected portion 267 blocks the detecting optical path 207c. If there is such detection, it is noticed to an operator or the like by means of at least display screen, lamp, buzzer, and pseudo-voice. Simultaneously, the electronic-component mounting apparatus can be automatically shut down.

The present invention is not limited to a concrete structure in the above second embodiment of the present invention. The concrete pressing state of the arm 214a of the tape presser 214 and the shutter 215 to the taping component 211, the pull-out structure of the caver tape 211A, the opening and closing system of the shutter 215, or the like can be designed in various ways. In addition, the operation system for automatically lifting the tape presser 214 to the release position and the method of energization can be also modified in various ways. For instance, other elastic member which performs the same action may be substituted for the helical compression spring 273.

### (Third Embodiment)

The third embodiment of the present invention solves the above individual problems and attains the main object of the present invention by constructing the component feeding device 310 for dealing with a taping component 300 as shown in Fig. 17 to Fig. 19 such that a tape presser 314 is not inclined with respect to the taping component 300 even though a thickness of the carrier tape 301 of the taping component 300 is varied.

The component feeding device 310 in accordance with the third embodiment has the basic configuration and action in common with the respective component feeding devices 8, 200 of the first and second embodiments, and is mounted on the electronic-component mounting apparatus as shown in Fig. 13 referenced in the first embodiment to feed an electronic component. Therefore, redundant description will be omitted and the device main body 302 in the component feeding device 310, and the relation between a tape guide 312 and the tape presser 314 of the device main body 302 will be mainly described below.

In the component feeding device 310 shown in Figs. 17 to 19, a carrier tape 301 where an electronic component 305 is accommodated in a hollow portion 303 and the upper surface thereof is then covered with a cover tape 304 moves along the components feeding guide 312 in the direction of the arrow a shown in Fig. 18. In addition, for stably moving the carrier tape 301, the carrier tape 301 is pressed against the upper surface of the components feeding guide 312 by the tape presser 314. The tape presser 314 has a cover portion 314a extending like a reversed U shape with a flat upper end from an elongated substrate 314c along one side surface to the other side surface of the body's main body 302. In the middle portion of the cover portion 314a in the direction of moving the taping component 300, the upper surface and the back surface thereof are notched. Then, a pressing portion 314b in the shape of the letter L in cross section is arranged on the notched middle portion and is then attached on a substrate 314c by means of two long holes 307 and two pins 306 engaging with the respective long holes 307 as shown in Fig. 19, so that the pressing portion 314b substantially pulls out the cover tape 304 of the tape presser 314 to press the electronic component 305 and the carrier tape 301.

The cover tape 304 is peeled off at a peeling portion 315 in the shape of a slit formed in the pressing portion 314b during the movement of the carrier tape 301 between the components feeding guide 312 and the tape presser 314 in the direction of the arrow a. The carrier tape 301 moves more, so that the electronic component 305 fed to a window portion 316 formed in the pressing portion 314b can be allowed to be picked up through the window portion 316 for sequentially feeding the electronic components 305. For the peeling-off of the cover tape 304 and the feed of the electronic component 305, the pressing portion 314b can be conveniently moved back and forth at a proper timing just as in the case with the shutter 215 of the second embodiment.

The tape presser 314 has a to-be-supported portion 317 which is provided on the end portion of the upper side of the substrate 314c in the direction of transferring the taping component 300 and is supported to move between an operative position shown in Fig. 17 to Fig. 19 where the taping component 300 is pressed against the tape guide 312 and a release position where the above pressing is released by escaping above the tape guide 312. The to-be-supported portion 317 is supported on the device main body 302 so as to freely move up and down and oscillate at an axially supporting portion 321. The axially supporting portion 321 has a shaft 323 arranged in a long hole 322 formed in the tape guide 321 to freely move up and down as described in Fig. 17 and Fig. 18. The shaft 323 can be moved up and down in the long hole 322 together with the to-be-supported portion 317 of the tape presser 314, and concurrently the tape presser 314 can be oscillated around the shaft 323. The shaft 323 is energized downward by a spring 324 in the long hole 322 and downwardly pulls the to-be-supported portion 317 to press the rear end side of the tape presser 314 against the tape guide 312.

Furthermore, a fixed roller 325 is provided on a position above the axially supporting portion 321 in the direction of transferring the taping member 300 fixed in place by a shaft 325a so as to be rotated while keeping a spacing with the tape guide 312 of more than or equal to the maximum thickness of the taping component 300. In conjunction with this, a detection lever 27 related to a part of the axially supporting portion 321 and a lower portion of the fixed roller 32 is supported by the device main body 302 such that a part thereof is rotatable with a shaft 328. The end portion of the detection lever 327 on the side of axially supporting portion 321 is connected to the axially supporting portion 321 so as to rotate around the shaft 323, while the detection roller 326 located below the fixed roller 326 is attached on the end portion of the detection lever 327 on the side of the fixed roller 325 by means of the shaft 326 such that the detection roller 326 is rotatable around the shaft 326. The detection lever 327 can be turned counterclockwise around the shaft 328 as the shaft 323 is energized downward by the spring 324, so that the detection roller 326 is stabilized at a position where the detection roller 326 makes press-contact with the fixed roller 325 and a height position of the to-be-supported portion 317 is restricted such that the pressing portion 314b makes contact with the tape guide 312. That is, the height position of the to-be-supported portion 317 varies depending on a distance of which the detection roller 326 downwardly moves away from the fixed roller 325. Consequently, when the taping component 300 is passed between the fixed roller 325 and the detection roller 326, the detection roller 326 moves away from the fixed roller 325 depending on the thickness thereof. The position of the axially supporting portion 21, i.e., the position of the to-be-supported portion 317 of the tape presser 314 varies depending on the thickness of the taping member 300. Furthermore, the thickness of the carrier tape 301 varies depending on the dimensions of the electronic component 305 to be accommodated. However, as the thickness of the cover tape 304 is constant, the positions of the above axially supporting portion 21 and the to-be-supported portion 317 vary depending on the thickness of the carrier tape 304.

The shaft 323 of the axially supporting portion 321 is, as shown in Fig. 20, connected to a screw 31 by its one end so as to sandwich the device main body 302 between them. In the long hole 322, however, it is attached with play allowing the shaft 323 to move up and down. As the to-be-supported portion 317 of the tape presser 314 and one end of the detection lever 327 are connected to the shaft 323 so as to be independently turned around the shaft 323, two staged different diameter portions 329a, 329b formed on the other end of the shaft 323 is fitted with the above to-be-supported portion 317 and one end of the detection lever 327 so as to be turned and one screw 30 is connected to the other end of the shaft 323 so as to be shared as a stopper for preventing them from coming out.

On the tip of a cover portion 314a of the tape presser 314, which is on the lower side in the direction of transferring the taping component 300, there is provided a hook portion 319 which can be engaged with pull-down means 320 formed on the tip of the device main body 302 as shown in Fig. 18. The pull-down means 320 comprises: a pull-down lever 332 having an upper end on which an engaging claw 332a is formed for the hook portion 319; a shaft 333 that supports the pull-down lever 332 such that the pull-down lever 332 is allowed to move up and down and to oscillate; and a spring 334 that downwardly energizes the pull-down lever 332. It is configured that the engagement with the hook portion 319 can be released by oscillating the pull-down lever 332 around the shaft 333 counterclockwise while pushing the pull-down lever 332 down against the spring 334, and the engagement with the hook portion 319 can be attained by turning the pull-down lever 332 clockwise while pushing the pull-down lever 332 up against the energization force of the spring 334. If the pull-down lever 332 is engaged with the hook portion 319, the energization of the spring 334 pulls the tip side of the tape presser 314 downward and pushes it against the tape guide 312.

Here, the detection roller 326 and the detection lever 327 detect the thickness of the taping component 300 or the carrier tape 301, conducting the function of restricting the height of the to-be-supported portion 317 of the tape presser 314 depending on the result of the detection.

From the above configuration, the hook portion 319 of the tape presser 314, formed in the end portion of the tape presser 314 on the lower side in the direction of transferring component 300, is pulled down by the pull-down means 320. On the end portion on the upper side in the direction of transferring the taping component 300, the to-be-supported portion 317 is supported by the axially supporting portion 321 so as to be freely oscillated up and down. The height position of the to-be-supported portion 317 varies depending on the thickness of the carrier tape 301 detected by the fixed roller 325 and the detection roller 326 through the axially supporting portion 321 and the detection lever 327. Even if the thickness of the carrier tape 301 varies, the upper surface of the carrier tape 301 is covered under the condition of being always pressed substantially in parallel by the pressing portion 314b of the tape presser 314. Therefore, the electronic component 305 can be perfectly prevented from revolution and vibration to be caused by the vibration of the carrier tape 301 at the time of feed movement or the like, so that electronic components 305 can be always fed in an appropriate manner.

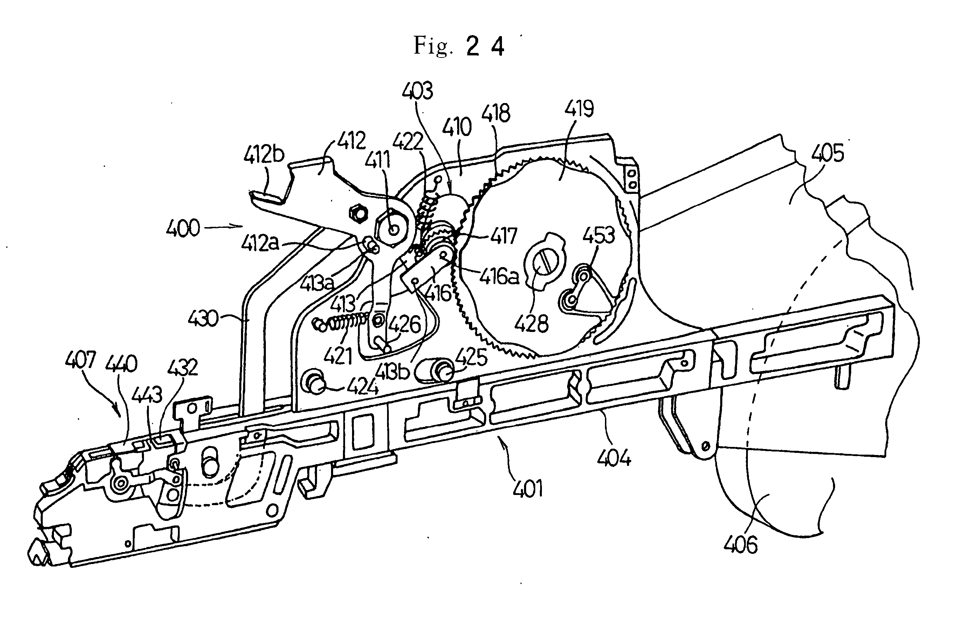

Referring now to Figs. 21 to 23 for more detailed description, even though the thicknesses of the taping components 300 are different from each other as indicated by d₁ in Fig. 21, d₂ in Fig. 22, and d₃ in Fig. 23, the upper surface of the taping component 300, i.e., the upper surface of the cover tape 304 is retained by the fixed roller 325 such that it is always regulated at a predetermined height. Therefore, if the thickness d₁ shown in Fig. 21 is thicker than others, it can be pushed down at a distance more than the others shown in Fig. 22 and Fig. 23 for the thickness d₁. If the thickness d₂ shown in Fig. 22 is an intermediate one, it can be pushed down at a distance as much as the intermediate height between those of Fig. 21 and Fig. 23 for the thickness d₂. If the thickness d₃ shown in Fig. 23 is thinner than others, it can be pushed down at a distance smaller than those of Fig. 21 and Fig. 22 for the thickness d₃.

The difference in the thicknesses of the taping components 300 is the difference in the push-down positions of the detecting roller 326 depending on the difference in the thicknesses of the carrier tapes 301 when the thickness of the cover tape 304 is constant, so that the positions of moving the axially supporting portion 321 and the to-be-supported portion 317 up and down through the detection lever 327 are regulated. As a result, the height of the tape presser 314 on the upper side in the direction of transferring the taping component 300 is arranged at a height corresponding to the thickness of the carrier tape 301. Consequently, even though the thickness of the carrier tape 301 is not limited to, the tape presser 314, especially the upper side of the pressing portion 314b in the direction of transferring the taping component 300 can be freely determined to approach, contact, or press the carrier tape 301 in a predetermined state. The lower side of the arm 314a of the tape presser 314 in the direction of transferring the taping component 300 is pulled down by the above pull-down means 320 to push the tape presser 314, especially the lower side of the pressing portion 314b in the direction of transferring the taping component 300 against the carrier tape 301, allowing the carrier tape 301 to be pressed in parallel with it and to be moved along the tape guide 312 in a stable manner.

In addition, when the taping component 300 is maintained, the engagement between the hook portion 319 and the pull-down means 320 is released by the procedures described above, so that the lower side portion of the tape presser 314 in the direction of transferring the taping component 300 can be oscillated upward and opened, resulting in easy maintenance.

In the third embodiment of the present invention, furthermore, the fixed roller 325 is engaged with the upper surface of the carrier tape 301 and the detection roller 326 is engaged with the lower surface thereof, followed by reversing the up and down movements of the detection roller 326 by the detection lever 327 supported at the halfway portion to adjust the height position of the tape presser 314. Therefore, the energization force of the spring 324 to push down the axially supporting portion 321 acts on the detection roller 326, followed by being retained by the fixed roller 325 through the taping component 301. Thus, it cannot be acted as a force of which the tape presser 314 presses against the carrier tape 301. Therefore, the energization of the spring 324 presses the carrier tape 301 substantially in parallel with each other without causing a large friction resistance at the time of feed-movement of the carrier tape 301, so that light and stable transfer movement of the carrier tape 301 can be obtained. In addition, the simple and cost-effective configuration with the oscillation movement of the detection lever 327 allows the tape presser 314 to be moved in parallel by adjusting the position of the axially supporting portion 321 depending on the thickness of the carrier tape 301 at a high reliability in the operation.

By the way, in the third embodiment of the present invention, the detection roller 326 is engaged with the lower surface of the carrier tape 301. Alternatively, the detection roller 326 may be engaged with the upper surface of the taping component 300 moving on the tape guide 312 or the fixed roller 325 so that the change in the position of the detection roller 326 may be coordinated with the axially supporting portion 321 being guided so as to be freely movable up and down by appropriate coordinating means. In this case, also, it is possible to obtain a stable transfer movement of the carrier tape 301 without causing a large friction resistance at the time of feed-movement of the carrier tape 301.

Furthermore, the axially supporting portion 321 may be guided so as to be movable up and down by guiding means such as the long hole 322. In addition, the axially supporting portion 321 may be energized downward by appropriate energization means such as the spring 324 to push the tape presser 314 against the upper surface of the carrier tape 301. In this case, however, a disadvantage in which a large friction resistance can be generated at the time of feed-movement of the carrier tape 301 can be generated.

In addition, the supporting portion 317 on the upper side of the tape presser 314 in the direction of transferring the taping component can be supported on the axially supporting portion 321 so as to be freely oscillated up and down while engaging the hook portion 319 on the lower side with the pull-down means 320. In addition, position-adjusting means for changing the height position of the axially supporting portion 321 depending on the thickness of the carrier tape 301 is provided. While exerting the above effects, at the time of maintaining the taping component 300, the end portion on the lower side of the tape presser 314 can be opened by oscillating upward by releasing the engagement between the hook portion 319 and the pull-down means 320, resulting in easy maintenance.

In addition, the position-adjusting means comprises supporting means for supporting the axially supporting portion 321 to be vertically movable and means for downwardly energizing the axially supporting portion 321. By the simple configuration, the change in thickness of the carrier tape 301 may be followed to automatically adjusting the position of the axially supporting portion 321.

Furthermore, the position-adjusting means may comprise: the detecting roller 326 which moves up and down in response to the change in the thickness of the taping component 300 by engaging therewith; and coordinating means for coordinating the positional change of the detection roller 326 with the movement of the axially supporting portion 321, where the detection roller 326 detects the thickness of the taping component 300 or the carrier tape 301 to adjust the position of the axially supporting portion 321. Therefore, the tape presser 314 can be moved in parallel depending on the change in thickness of the carrier tape 301.

Furthermore, the position-adjusting means may comprise: the fixed roller 325 engaging with the upper surface of the taping component 300; the detection roller 326 that engages with the lower surface of the carrier tape 301 of the taping component 300 at a position opposite to the fixed roller 325 and moves up and down in response to the change in thickness thereof; the detection lever 327 having one end connected to the detection roller 326, the other end connected to the axially supporting portion 321, and the middle portion thereof supported in a rotatable manner; and the energization means for energizing the axially supporting portion 321 so as to move downward, where the detection lever 327 is oscillated depending on the change in thickness of the carrier tape 301, and the axially supporting portion 321 can be subjected to a positional adjustment, so that the oscillation movement of the detection lever 327 is able to move the tape presser in parallel at a high operational reliability with a simple and cost-effective configuration.

### (Fourth Embodiment)

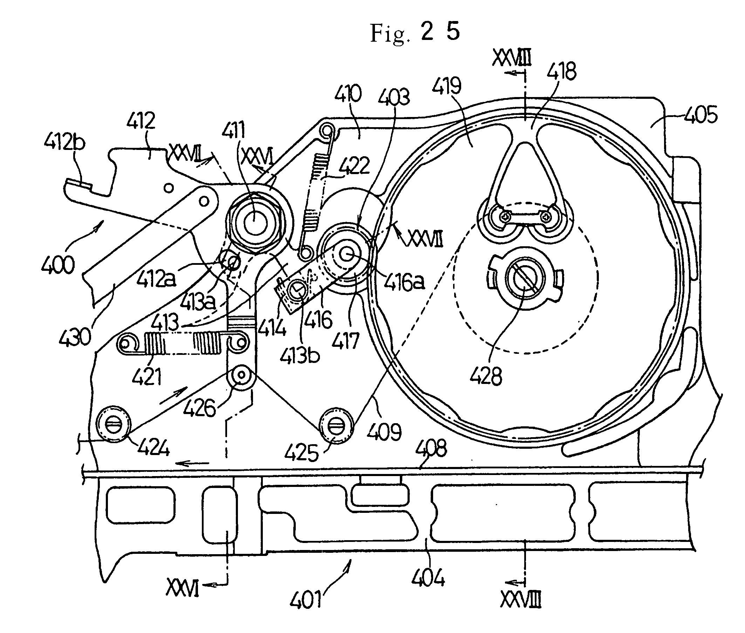

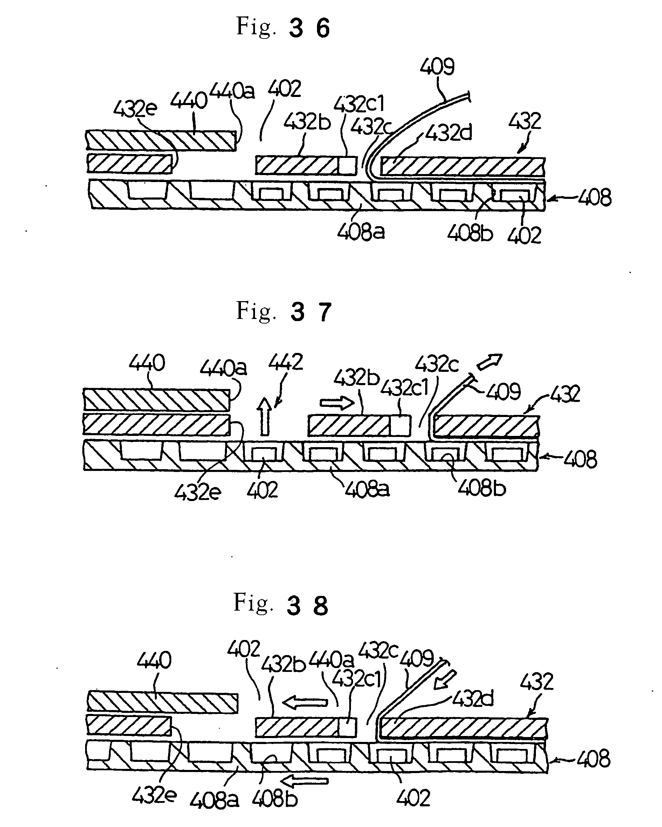

A fourth embodiment of the present invention is a cover-tape winding mechanism 403 shown in Fig. 24 and Fig. 25 of a component feeding device 401 dealing with a taping component 408 as shown in Fig. 25 and Fig. 36, where a driving member performs a reciprocating movement and engages with a claw wheel 418b, and an outgoing movement of the driving member revolves the claw wheel 418b to wind a cover tape 409 up, while keeping such a winding state without reversely revolving the claw wheel 418b at the time of a returning movement of the driving member, so that it will solve the above individual problems in the driving member using the conventional claw and will attain the main object of the present invention.

The component feeding device 401 in accordance with the fourth embodiment of the present invention has the basic configuration and action in common with the respective component feeding devices 8, 200, 310 of the first to third embodiments, and is mounted on the electronic-component mounting apparatus as shown in Fig. 13 referenced in the first embodiment to feed an electronic component. Therefore, in the following description, the cover-tape winding mechanism 403 and a tape presser 440 modified on the base thereof will be mainly described in addition to the related items thereof, while redundant description will be omitted if possible.

The component feeding device 401 shown in Fig. 24 and Fig. 25 mainly comprises a device main body 404 having a components feeding unit that feeds an electronic component 402 (Fig. 36) in response to a command (push-down movement) from the electronic-component mounting apparatus, and a reel holding portion 405 connecting to the device main body 404 and holding a components-winding reel 406 on which a taping component 408 is wound.

As shown in Fig. 24, the device main body 404 comprises a cover-tape winding mechanism 403, a components feeding unit 407, and a driving force transmitting unit 400 for driving each of them, in which some components of the structural components thereof correspond to those of the cover-tape winding mechanism 403 and the components feeding unit 407.

As shown in Fig. 25 to Fig. 28, the cover-tape winding mechanism 403 is fixed on a frame 410 provided on the device main body 404 and comprises: a feed lever 412 which can be turned around a supporting-point shaft 411 in response to a push-down movement from the electronic-component mounting apparatus; a winding lever 413 using the supporting-point shaft 411 as the center of its turn and extending from this turning center portion so as to be substantially shaped like the letter V, where one end thereof has a protruded portion 413a to be inserted into an opening 412a of the feed lever 412, and the winding lever 413 can be turned when the protruded portion 413a touches on the inner wall surface of the opening 412a as the feed lever 412 turns; a gear arm 416 supported on the other end of the winding lever 413 such that it can be turned by a shaft 413b; a wind-up gear 417 supported on the tip of the gear arm 416, having a one way clutch (a second one way clutch) so as to be only allowed to turn counterclockwise by a shaft 416a; and a winding reel 418 having a peripheral surface with teeth, which is attached on the device main body 404 through a one way clutch (a first one way clutch) so as to be only allowed to turn clockwise around a shaft 428 in the direction of winding.

A claw wheel 418b is integrally formed on the winding reel 418 by providing teeth on the outer periphery of the winding reel 418. However, it may be formed as a separate component. A winding cap 419 is attached on the winding reel 418 so as to face to the winding reel 418, so that a cover tape 409 can be wound on between the winding reel 418 and the winding cap 419.

The feed lever 412 is energized by a coil spring 421 for a returning movement such that a to-be-pressed portion 412b of the feed lever 412 is always return to a move-up position, the winding lever 413 is energized by a winding spring 422 fixed on the frame 410 such that it turns counterclockwise around the shaft 411, the protruded portion 413a is arranged such that it always touches on the lower end portion of the opening 412a, and the gear arm 416 is energized clockwise around the shaft 413b by a spring 414 to press the wind-up gear 417 against the claw wheel 418a formed on the winding reel 418 so as to be always engaged with each other.

On the frame 410, guide rollers 424, 425 for guiding and supporting the cover tape 409 are supported in a rotatable manner. A charge roller 426 is provided between the guide rollers 424, 425 and is supported on the lower end portion of the feed lever 411 in a rotatable manner, where the cover tape 409 guided and supported by the guide rollers 424, 425 can be subjected to a charge action.

The cover tape 409 is suspended on the guide rollers 424, 425 after being peeled off from the taping component 409 and is then wound on the winding reel 418. Subsequently, as shown in Fig. 25, the cover tape 409 is pulled upward by the charge roller 426 between the guide rollers 424, 425.

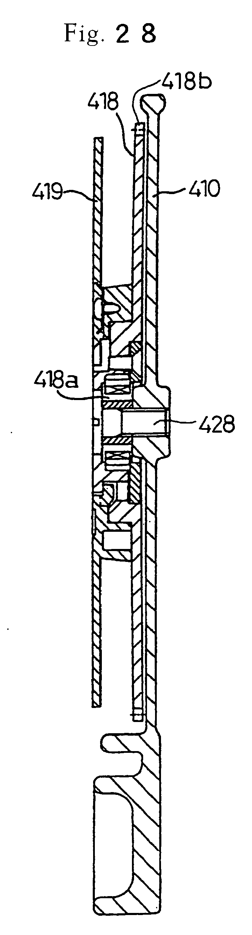

In the above configuration, when a push-down movement is applied from the electronic-component mounting apparatus to the to-be-pressed portion 412b formed on the tip of the feed lever 412 in an initial state shown in Fig. 25 and Fig. 28 where the feed lever 412 is not pushed down, as shown in Fig. 30, the feed lever 412 oscillates counterclockwise around the supporting-point shaft 411 in opposition to energization of the coil spring 421. At this time, by means of a pulling force of the winding spring 422, the winding lever 413 turns counterclockwise around the supporting-point shaft 411 together with the feed lever 412 while the protruded portion 413a thereof follows the movement of an inner wall of the opening 412a of the feed lever 412 being oscillated counterclockwise, pushing the gear arm 416 and the wind-up gear 417 attached on the tip thereof to move. At this time, the wind-up gear 417 moves counterclockwise around the outer periphery of the claw wheel 418b while engaging with the claw wheel 418b. However, the one way clutch 417a blocks turning counterclockwise around the shaft 416a, so that the claw wheel 418b is pushed and turned in the winding direction which is permitted by the one way clutch 417a with a portion of engaging with the claw wheel 418b. As the winding reel 418 turns together with the rotation of the claw wheel 418b, so that the cover tape 409 can be wound on the winding reel 418. Furthermore, the feed lever 412 oscillates counterclockwise as described above, so that the charge roller 426 can be also oscillated in the same direction. Therefore, between the guide rollers 424, 425, the cover tape 409 in a state of being pulled up is additionally obliquely pulled up backward and is then charged, so that it may contribute to wind the cover tape 409 around the winding reel 418 and to the peeling-off described in the first to third embodiments in the components feeding unit 407.

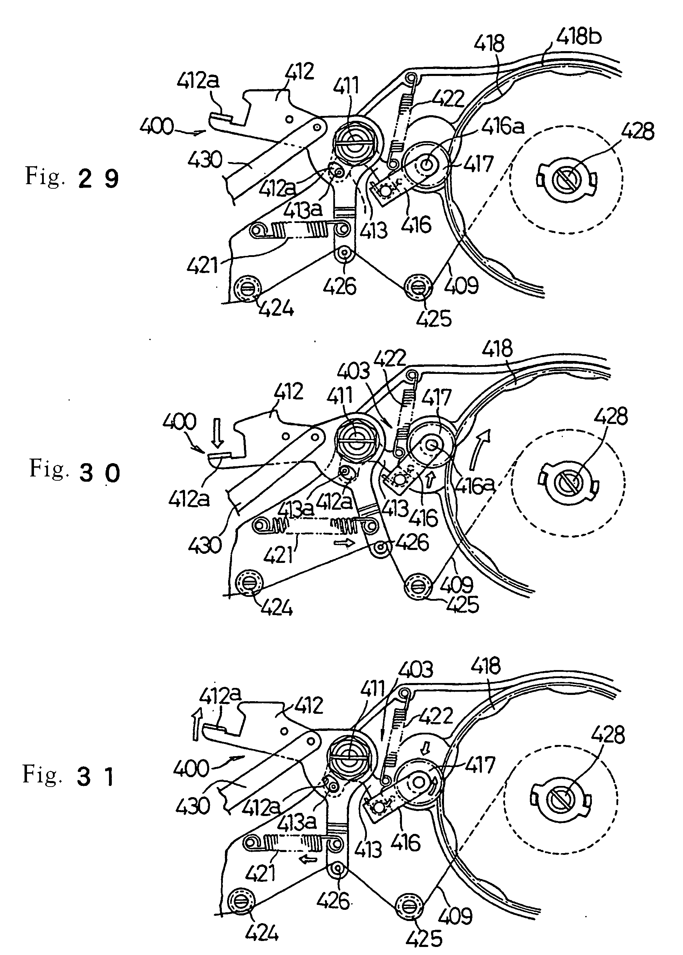

When the feed lever 412 is released from being pushed down, the feed lever 412 is retuned to the initial state by oscillating clockwise around the supporting-point shaft 411 by the energization of the coil spring 421 as shown in Fig. 31. At this time, the winding lever 413 is pushed and moved to the inner wall of the opening 412a formed in the feed lever 412 through the protruded portion 413a such that it oscillates in the same direction in opposition to the energization of the winding spring 422. Therefore, the winding lever 413 is pulled back in the direction in contrast to the case shown in Fig. 30 and is returned in the initial state together with the gear arm 416 and the wind-up gear 417. As a result, the wind-up gear 417 moves clockwise around the outer periphery of the claw wheel 418b while engaging with the claw wheel 418b. However, the one way clutch 418b blocks the counterclockwise turning of the claw wheel 418b, so that it cannot turn counterclockwise in the direction opposite to the direction of winding. Therefore, there is no possibility of loosing the preceding winding of the cover tape 409. On the other hand, the wind-up gear 417 moves to the initial state without trouble of connection, resistance, or the like by turning free around the shaft 416a in the permitted counterclockwise direction by the one way clutch 417a while engaging with the claw wheel 418b.

As described above, for turning the winding reel 418 only in the direction of winding, the one way clutches 417a, 418a, and the wind-up gear 417 are used. Therefore, a stable winding operation can be allowed without causing a delay before the teeth is engaged with each other resulting from the engagement between the claw wheel and claws as shown in the ratchet system or the like. Therefore, the cover tape 409 can be perfectly wound up, so that the reliability in winding operation can be increased. Furthermore, as the teeth engage with each other, the movement is performed smoothly and the frequency of the engagement of one tooth can be also significantly decreased. In addition, wears and defections are hardly occurred because of no movement in which the claw climbs over the tooth of the claw wheel at the time of returning movement in the ratchet system. Therefore, the durability can be improved. Furthermore, the engagement is performed between toothed gears, so that the motion noise is extremely small, extensively contributing the reduction of noise generated from the whole device. Therefore, the required number of maintenances decreases while the productivity increases. In addition, the cost for maintenance can be reduced. As the mechanism itself is simply constructed, the maintenance can be easily performed, for example compared with the construction obtained by combining a plurality of one way clutches on the same shaft. Furthermore, it can be shaped thinner and the cost can be also reduced.

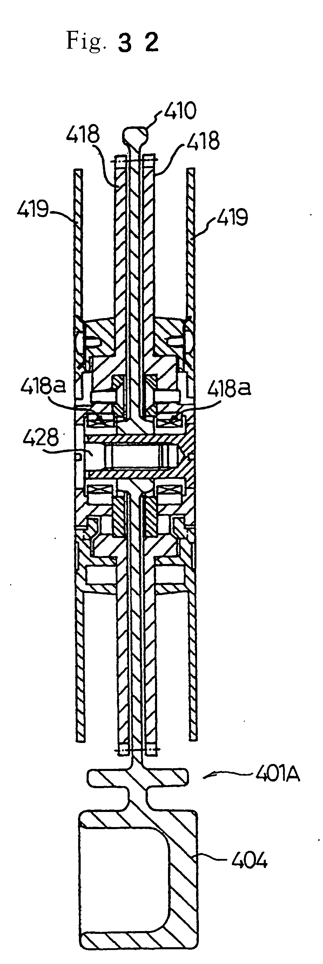

By the way, the component feeding device 401 shown in Fig. 24 to Fig. 28 is constructed as a single type in which the cover-tape winding mechanism 403, the components feeding unit 407, and the driving force transmitting unit 400 are provided on one side of the frame 410. Alternatively, it may be constructed as a double type in which the cover-tape winding mechanism, the components feeding unit, and the driving force transmitting unit are provided on both sides of the frame. An example of this case is representatively shown in Fig. 32 with respect to the winding reel 418.

As shown in Fig. 32, in the double-type configuration, the rotation shaft 428 of the winding reel 418, the supporting-point shaft 411, and so on are commonly used, while substantially the same members and required mechanisms are symmetrically arranged with respect to the frame 410 used as a boundary thereof. According to the component feeding device 401A of this double type, two kinds of taping components 80 can be mounted on a single component feeding device A, and two kinds of electronic components 2 can be supplied to the electronic-component mounting apparatus B. In this case, especially in the type of constructing one way clutches 418a, 418a on the same shaft, it is hard to get thinner, so that the number of the component feeding device 400A to be mounted on a limited space can be reduced.

By the way, the above driving force transmitting unit 400 mainly comprises the feed lever 412, the winding lever 413, the gear arm 416, and the spring 414.

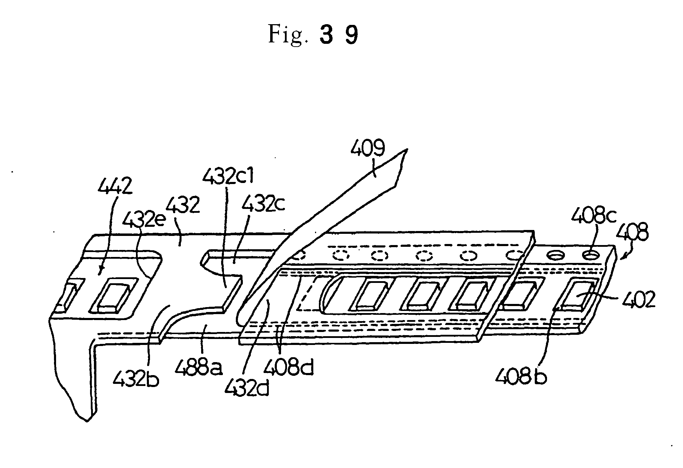

As shown in Fig. 33 to Fig. 35, the components feeding unit 407 comprises: an oscillation lever 431 which is supported on the device main body 404 so as to be rotated by a shaft 461, having a free end coupled with a link 430 connected to the feed lever 412 through a pin 461A and a halfway portion on which a shutter driving arm 431a is formed; a shutter 432 supported in a slidable manner, on which a notch 432a for engaging with the pin 431a is formed; a sprocket wheel 433, which is coaxially supported with the oscillation lever 431 and is engaged with a perforation 408c shown in Fig. 39 of the taping component 408, while performing a pitch-feeding of the taping component 408 in connection with intermittent rotation; a claw wheel 435 integrally formed with the sprocket wheel 433; a claw 436 energized by a helical torsion coil spring such that the tip of the claw 436 can be engaged with the claw wheel 435, which is supported on the free end of the oscillation lever 431 so as to turn about a shaft 462 and can be intermittently driven only in the direction of pitch-feeding of the taping component 408; a backstop lever 439 which is supported on the device main body 404 so as to turn about a shaft 463 and can be engaged with the claw wheel 435 by energization of the coil spring to prevent the claw wheel 435 from reversely turning; and a tape presser 440 which has an opening 440a formed in the upper surface of the shutter 432 and is fixedly provided for preventing an electronic component 402 from being flew out of various kinds of storage portions such as a hollow portion 408b (Fig. 36) of the carrier tape 408a in the taping component 408.

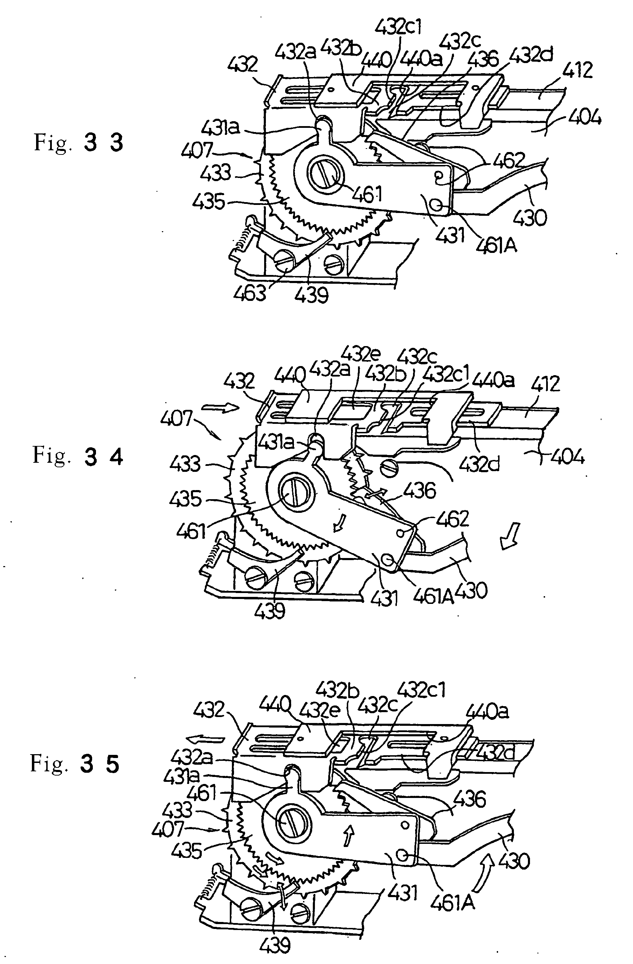

The shutter 432 is capable of sliding in the direction indicated by an arrow in Fig. 34 through the link 430 and the oscillation lever 431 in response to a force brought by pushing the feed lever 412 down from the driving force transmitting unit 400 described above, and is capable of returning in the direction indicated by an arrow in Fig. 35 in connection with a returning movement of the feed lever 412.

In the shutter 432, as shown in Fig. 33 to Fig. 38, a pick-up window 432e and a slit 432c are formed in a pressing portion 432b. The pick up window 432e is responsible for opening and closing a pick-up position 442 for the electronic component 402 communicated with the opening 440a of the tape presser 440. The slit 432c is provided for pulling the cover tape 409 peeled off from the carrier tape 408a out of the taping component 408. The pressing portion 432b covers the carrier tape 409 from a portion where the cover tape 409 is peeled off on the lower side in the direction of transferring the taping component 408. As shown in Fig. 33 to Fig. 35 and Fig. 39, the slit 432c has a protruded piece 432c1 as an middle portion extending from the downstream to the upstream in the direction of transferring the taping component 408, which is formed on the edge of the opening on the lower side in the direction of transferring the taping component 408. That is, it is characterized in that the slit 432c formed in the shutter 432 is opened so as to be narrowed in the upper surface area corresponding to the hollow portion 408b of the taping component 408 and so as to widely open the upper surface area on the both sides in the width direction corresponding to the bonded line 408d between the carrier tape 408a and the cover tape 409 as shown in Fig. 39, while deviating from the hollow portion 408b of the cover tape 409. The slit 432c having such a protruded piece 432c1 can be advantageously effected when the caver tape 409 is peeled off by the guide portion 432d which presses against the upper surface of the taping component 408 at the time of moving the above shutter 432 backward to the upper side in the direction of transferring the taping component 408.

It will be now described below. The link 430 moves downward in connection with oscillation caused at the time of pushing the feed lever 412 down from the electronic-component mounting apparatus, so that the oscillation lever 431 can be turned clockwise around the shaft 461 as indicated by an arrow in Fig. 34 and Fig. 37 from the initial state shown in Fig. 33 and Fig. 36. Consequently, the arm 431a of the oscillation lever 431 allows the shutter 432 to slide toward the right side in the figure through the notch 432a of the shutter 432. At this time, the cover tape 409 is wound on by means of the cover-tape winding mechanism 403 described above, while being peeled off from the carrier tape 408a with the guide portion 432d on one side of the slit 432c in the shutter 432 being moved. At this time, the claw 436 sliding on teeth of the claw wheel 435 is moved by following the oscillation of the oscillation lever 431, while the claw wheel 435 is still arrested as the backstop lever 439 prevents it from reversely turning.

As the shutter 432 moves as described above, the pick-up window 432e is opened as shown in Fig. 34 and Fig. 37 at a position 442 where the component can be picked up. Under such a condition, the electronic component 402 at the pick-up position 442 is sucked and held by the suction nozzle described above or the like on the side of the electronic-component mounting apparatus through the pick-up window 432e and the opening 440a of the tape presser 440. Then, the electronic component 402 is fed for the mounting on a circuit board or the like.

Subsequently, when the feed lever 412 is released from being pushed down and is then returned to its initial state, while the link 430 and the oscillation lever 431 return to their initial states as indicated by the arrow shown in Fig. 35 and Fig. 38 in a cooperative manner, the claw 436 is engaged with the claw wheel 435 to allow the claw wheel 435 and the sprocket wheel 433 integrated with the claw wheel 435 to intermittently turn clockwise, causing a pitch-feed of the taping component 408. At this time, the backstop lever 439 becomes in a state of preventing the claw wheel 435 from being turned in the reverse direction at the position of arresting the intermittent rotation of the claw wheel 435 without interrupting such an intermittent rotation by sliding against the teeth of the claw wheel 435 to be intermittently turned. Furthermore, the cover tape 409 can be slightly pulled toward the components feeding unit 407 as the shutter 432 slides in the direction of returning movement as indicated by the arrow in Fig. 35. However, the charge roller 426 of the cover-tape winding mechanism 403 shown in Fig. 31 returns to its initial position, so that it can be cancelled by slight return of the cover tape 409.

As described above, in the shutter 432 constructed as described above, as shown in Fig. 39, the slit 432c has cut-back portions corresponding to the bonded lines 408d between the slit cover tape 409 and the carrier tape 408a. Therefore, even if the cover tape 409 is substantially pulled under the lower surface of the pressing portion 432b, the cover tape 409 can be prevented from being pulled under the shutter 432 to be jammed because the pressing portion 432b is not located above the above bonded lines 408d. Furthermore, such a trouble can be prevented by pushing the middle portion of the cover tape 409 with the protruded piece 432c1. They work together to reliably prevent the cover tape 409 not completely peeled off from being pulled under the shutter 432 to be jammed. Therefore, there is no need to provide any maintenance for such cases or the required number of such a maintenance decreases, so that the productivity can be increased.

In the slit 432c, the protruded piece 432c1 covers the hollow portion 408b of the carrier tape 408a after peeling the cover tape 409 off, so that the electronic component 402 can be perfectly held in the hollow portion 408b without flying out thereof. Therefore, in addition to preventing the cover tape 409 from being jammed, a mistake of feeding the electronic component 402 or a trouble in the feed, or a mistake of the mounting or a trouble in the mounting to be caused by the mistakes of the formers are solved and the productivity is increased as the time loss depending on reattempts of the feed or mounting of components is diminished, resulting in the increase in productivity.

The protruded piece 432c1 of the pressing portion 432b in the shutter 432 described above may be alternatively shaped as, for example, each of various shapes shown in Fig. 40 to Fig. 44. Here, an example of the protruded piece 432c1 shown in Fig. 40 is of one having the tip portion substantially in the shape of a triangle. Alternatively, an example of the protruded piece 432c1 shown in Fig. 41 is one having the tip in the shape of a semicircle. An example of the protruded piece 432c1 shown in Fig. 42 is one divided into a plurality of pieces arranged in parallel with each other. An example of the protruded piece 432c1 shown in Fig. 43 is one shaped like a triangle which is provided on each of both upstream and downstream sides of the slit 432c in the direction of transferring the taping component 408. In an example shown in Fig. 44, the protruded piece 432c1 in the shape of a semicircle instead of a triangle is provided on each of the both directions.

According to the protruded pieces 432c1 formed on the pressing portions 432b and guiding portions 432d with various shapes as shown in Fig. 40 to Fig. 44, in either case, the hollow portion 408b of the above taping component 408 can be reliably covered and the electronic component 402 in the hollow portion 408b can be retained in a state of being accommodated. Furthermore, even though the cover tape 409 is pulled under the lower surface of the shutter 432, it can be prevented and any trouble to be affected on the mounting operation can be prevented in advance. Furthermore, the slit 432c is widely opened in both directions of upstream and downstream in the direction of transferring the taping component 408, so that the peeling-off of the cover tape 409 in the taping component 408 can be initiated without delay, resulting in a more stable peeling-off movement. In addition, by forming a plurality of protruded pieces 432c1, even though a large part which requires a wider taping component 408 can be reliably prevented from flying out, the cover tape 409 can be peeled off in a stable manner.

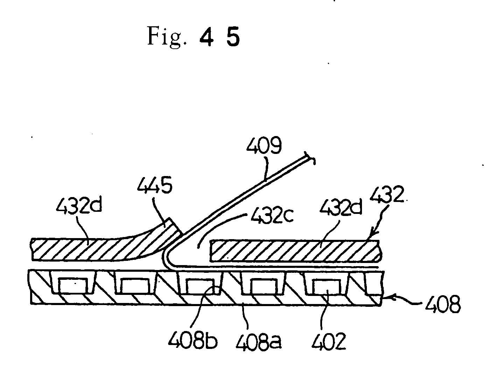

A still another example of the pressing portion 432b of the above shutter 432 is shown in Fig. 45. The pressing portion 432b of this case is formed such that the pressing edge 445 on the side of the slit 432c is slightly slanted upward toward the tip, so that the pressing edge 445 is curled up like a tapered shape. That is, on the side of the slit 432c opposite to the peeled-off side of the cover tape 409, the lower surface of the shutter 432 facing to the carrier tape 408a after the peeling-off of the cover tape 409 is slanted so as to be curled up in the direction of pulling the cover tape 409 out.

As is constructed in this manner, even though the peeling-off of the cover tape 409 is delayed and the cover tape 409 is pulled under the shutter 432, play can be provided on it to prevent the generation of jam and it can be easily pulled out. Furthermore, even though the electronic component 402 substantially fly out of the hollow portion 408b of the taping component 408, the electronic component 402 can be prevented from flying out by the tapered pressing edge 445, so that it can be smoothly returned to its original housing position.

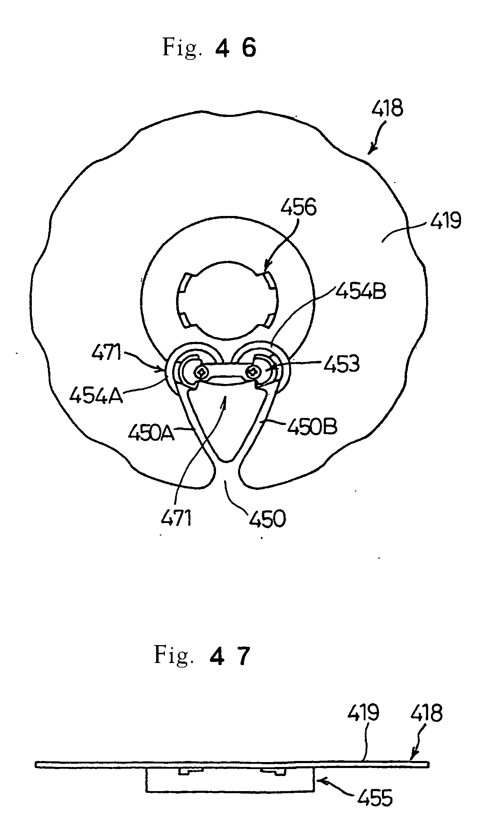

In the fourth embodiment of the present invention, the winding reel 418 of the cover-tape winding mechanism 403 is also uniquely designed. It will be described in detail below. The winding reel 418 in the cover-tape winding mechanism 403 of the fourth embodiment of the present invention includes a winding cap 419 as shown in Fig. 46 and Fig. 47. This winding cap 419 has a retaining portion 471 by which the tip of the cover tape 409 initially wound around a winding core portion 455 of the winding reel 418 by hand is retained to allow the cover tape 409 to be surely wound around. On the inside of the winding core portion 455, an engaging portion 456 to be engaged with the winding reel 418 is formed.

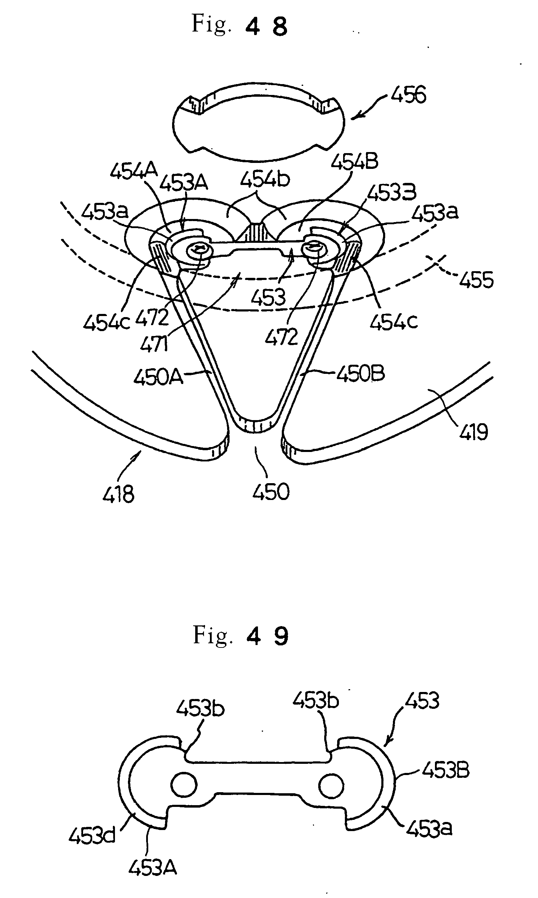

The retaining portion 471 comprises two retaining claws 453A, 453B, lead-in grooves 450A, 450B for guiding the cover tape 409 to them, guide grooves 454A, 454B, which are bilaterally symmetrical for dealing with the initial winding of the cover tape 409 on the winding core portion 455 of the winding reel 418 in the direction of either left or right. Each of the retaining claws 453A, 453B is formed in the shape of a semicircle around the end of the screw cramp portion of the elongated retaining member 453 made of a metal with both ends screwed on the winding cap 419 by screws 472. The cover tape 409 is sandwiched between the retaining claws 453A, 453B and the winding cap 419 around the screw cramp portions and is pressed and retained by means of an elasticity of the retaining claws 453A, 453B. The retaining member 453 may be one formed by die-cutting in the sheet metal processing as shown in Fig. 48 and Fig. 49.

The guide grooves 451A, 451B are prepared by indenting portions where the retaining claws 453A, 453B of the winding cap 419 are screwed so as to be formed as grooves around the retaining claws 453A, 453B. The slanted portions 453a are formed on the outer peripheries of the retaining claws 453A, 453B such that they extend widely in the direction of leaving away from the winding cap 419. The guide grooves 451A, 451B, and the slanted portions 453a are able to guide the cover tape 409 wound around the retaining claws 453A, 453B such that the cover tape 409 can be slid between the winding cap 419 around the screw cramp portions of the retaining claws 453A, 453B.

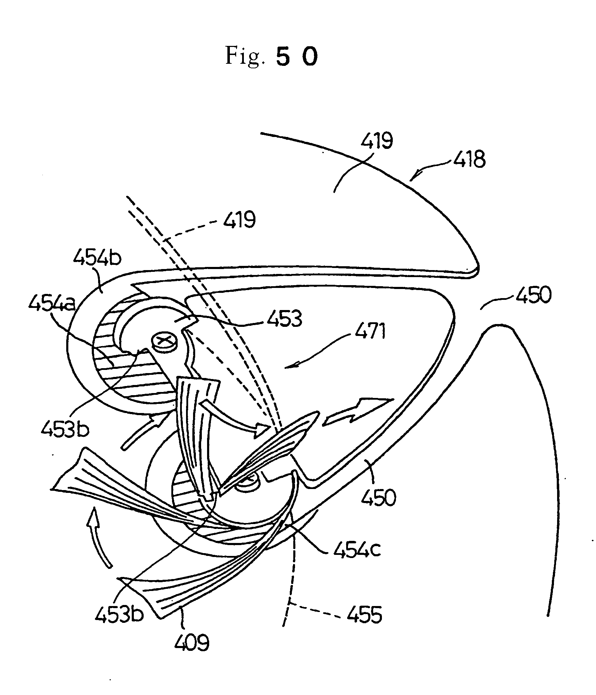

For such a guide, as shown in Fig. 48 and Fig. 50, each of the guide grooves 451A, 451B comprises bottom surfaces 454a, inclined surfaces 454b as outer peripheral portions of the bottom surfaces 454a, leading grooves 454c sharpened diagonally toward the lead-in grooves 450A, 450B on the end portions connected to the lead-in grooves 450A, 450B in the bottom surface 454a. The lead-in grooves 450A, 450B are formed by cutting into slits such that they are divided from one inlet 450 formed in the outer peripheral portion of the winding cap 419 and extend to the respective ends of the guide grooves 451A, 451B.

By the way, the edge portion 453b of each of the retaining claws 453A, 453B shown in Fig. 49 and Fig. 50 is kept in a state of without removing fins at the time of die-cutting. Such fins constitute a cutter portion capable of cutting an undesired portion of the cover tape 409 as shown in Fig. 50. Using such fins, there is no need to additionally form a blade surface, so that an edge portion can be formed at a low price. By the way, regarding such a cutter portion, two cutter portions are formed on symmetrical positions so as to be used from right and left directions.

Here, the edge portions 453b are pressed against the bottom surfaces 454a of the guide grooves 454A, 454B formed by hollowing the surface thereof. Therefore, the fabrication can be performed with safety without causing any injury to an operator. Other edge surfaces except the edge portions 453b are ground to avoid undesired cutting.

The operation for winding the cover tape 409 using the winding cap 419 will be described below.

At the time of initially attaching the taping component 408 on the component feeding device 404, the cover tape 409, which is peeled off from the carrier tape 408a, pulled out of the slit 432c of the shutter 432, and hanged on the guide rollers 424, 425 and the charge roller 426 as shown in Fig. 25, is wound on four components of the winding core portion 465 of the winding cap 419 as shown in Fig. 50. At this time, an operator inserts the tip portion of the cover tape 409 being pulled out into one of lead-in grooves 450A, 450B of the winding cap 419 covered on the winding reel 418 and introduces it into the winding core portion 465.

Subsequently, as shown in Fig. 50, after passing through the leading groove 454c, the cover tape 409 is inserted between the slanted portion 453a and the inclined surface 454b on the side corresponding to the guide grooves 454A, 454B and the retaining claws 453A, 453B, while winding up the cover tape 409. At this time, as the leading groove 454c, and the inclined surface 454b and the slanted portion 453a are provided, the cover tape 409 is easily sandwiched between the retaining claw 453A or 453B and the winding cap 419 with reliability. Therefore, the workability of fixing the tip of the cover tape 409 can be increased.

At last, the tip of the cover tape 409 is wound around the retaining claw 453A and 453B and is caught in a gap between the retaining claw 453A or 453B and the winding cap 419 around the screw cramp portion. Then, the tip of the cover tape 409 reached to the above edge portion 453b is taken off to cut an excessive portion of the cover tape 409 at the edge portion 453b. Therefore, the cover tape 409 is surely retained and held between the guide groove 454A or 454B and the retaining claw 453A or 453B and is fixed on the winding cap 419. Therefore, the cover tape 409 protrudes from the winding cap 419, so that there is no possibility of interfering with other members or the like during the rotation.

Consequently, the winding up of the cover tape 409 and the cutting off of the excess part are easily realized by a consecutive operation, so that the work efficiency can be increased and the setup time can be shortened, contributing the improvement in the productivity.

### INDUSTRIAL APPLICABILITY

According to a component feeding method and device of the present invention, and a component mounting apparatus using thereof, as described above, in the work for mounting the component feeding device on the components feeding table, the component feeding device can be surely fixed by one-touch operation including the positioning of the front end side of the component feeding device. In addition, under the condition where the tape presser is not locked in spite of feeding components by pressing the taping component with the tape presser, the tape presser is automatically lifted from the device main body such that the failure of lock can be easily detected. In addition, there is no possibility of forming a large gap between the taping component and the tape guide and the tape presser, so that the rotation or detachment of any component held on the carrier tape can be surely prevented. Furthermore, the delay in rotation and the delay in winding operation cannot be caused at the time of feeding components while winding the cover tape around the winding reel. In addition, the wear or defective is hardly generated in the gear, so that the durability can be increased. Therefore, the present invention prevents the failure of feeding components and the decrease in the productivity caused by maintenance, so that the replacement of component feeding device can be effectively performed, which can be advantageous for improving the productivity.

## Claims

1. A component feeding device comprising:
a component feeding part (407) wherein a component carrying tape (408) constituted by a tapelike member (408a) having accommodating spaces (408b) formed at a predetermined pitch in a lengthwise direction of the tapelike member for accommodating components (402) therein, the components being covered by a cover tape (409), is fed at a predetermined pitch and the cover tape is peeled off before a component feeding position; and
a cover tape winding-up device (403) for winding up the peeled-off cover tape,
wherein
the component feeding part includes a shutter (432) having a slit (432c) through which the cover tape peeled off from the component carrying tape is passed and drawn out, the feeding device further comprising a cover tape winding-up device includes a winding-up reel (418) for winding the peeled-off cover tape, and a locking claw (453) for holding the cover tape between the winding-up reel, and having an edge (453b) for cutting the cover tape.

2. The component feeding device according to claim *1*, wherein the slit (4320) of the shutter (432) is provided with a plurality of protrusions (432c1) for covering the accommodating spaces (408b) of the component carrying tape.

3. The component feeding device according to claim 1, wherein the edge (453_{b}) is made of burr produced by treating the locking claw (453).

4. The component feeding device according to claim 1, wherein the locking claw (453) is attached to a bottom surface (454a) of a groove (454A, 454B) formed in a surface of the winding-up reel (418).

5. The component feeding device according to claim 1, wherein an inviting groove (454c) for guiding the cover tape (409) is provided in the bottom surface (454a) of the winding-up reel (418).

6. A component feeding device according to claim 1, the cover tape winding-up device includes a winding-up reel (418) provided with teeth and having an axis (428) provided with a first one-way clutch (41 8a), a winding-up gear (417) engaging with the winding-up reel and including a second one-way clutch (417a), and a driving part (400) for driving the winding-up gear.

7. The component feeding device according to claim 6, wherein the driving part (400) is rotatably supported by a supporting axis (411) and connected to a spring (421) for energizing the driving part, a feed lever (412) having an end (412b), a winding-up lever (413) which interlocks with the feed lever, and a gear arm (416) supported by the winding-up lever and supporting the winding-up gear (417), the gear arm for energizing the winding-up gear toward to the winding-up reel (418).

## Patentansprüche

1. Komponenten-Zuführungsvorrichtung, umfassend:
einen Komponenten-Zuführungsabschnitt (407), wobei ein Komponenten-Beförderungsband (408), das durch ein bandähnliches Element (408 a) gebildet ist, welches Unterbringungsräume (408 b) aufweist, die in einem vorbestimmten Abstand in einer Längsrichtung des bandähnlichen Elements gebildet sind, um Komponenten (402) darin unterzubringen - wobei die Komponenten durch ein Deckband (409) bedeckt sind -, in einem vorbestimmten Abstand zugeführt wird und das Deckband vor einer Komponenten-Zuführungsposition abgezogen wird; und
eine Deckband-Aufwickelvorrichtung (403) zum Aufwickeln des abgezogenen Deckbandes,
wobei
der Komponenten-Zuführungsabschnitt einen Verschluss (432) einschließt, welcher einen Schlitz (432 c) aufweist, durch welchen das von dem Komponenten-Beförderungsband abgezogene Deckband hindurchgeführt und herausgezogen wird, wobei die Zuführungsvorrichtung ferner eine Deckband-Aufwickelvorrichtung umfasst, die eine Aufwickelspule (418) zum Wickeln des abgezogenen Deckbandes einschließt, und eine Sicherungskralle (453) zum Halten des Deckbandes zwischen der Aufwickelspule, wobei diese eine Kante (453 b) zum Schneiden des Deckbandes aufweist.

2. Komponenten-Zuführungsvorrichtung nach Anspruch 1, wobei der Schlitz (4320) des Verschlusses (432) mit einer Vielzahl von Vorsprüngen (432 c 1) zum Bedecken der Unterbringungsräume (408 b) des Komponenten-Beförderungsbandes ausgestattet ist.

3. Komponenten-Zuführungsvorrichtung nach Anspruch 1, wobei die Kante (453 b) aus Schnittgrat gebildet ist, welcher durch das Bearbeiten der Sicherungskralle (453) erzeugt wird.

4. Komponenten-Zuführungsvorrichtung nach Anspruch 1, wobei die Sicherungskralle (453) an einer unteren Oberfläche (454 a) einer Rille (454 A, 454 B) befestigt ist, die in einer Oberfläche der Aufwickelspule (418) gebildet ist.

5. Komponenten-Zuführungsvorrichtung nach Anspruch 1, wobei eine aufnehmende Rille (454 c) für das Führen des Deckbandes (409) in der unteren Oberfläche (454 a) der Aufwickelspule (418) ausgebildet ist.

6. Komponenten-Zuführungsvorrichtung nach Anspruch 1, wobei die Deckband-Aufwickelvorrichtung eine Aufwickelspule (418) einschließt, die mit Zähnen ausgestattet ist und eine Achse (428) aufweist, die mit einem ersten Einweggreifer (418 a) ausgestattet ist, ein Aufwickelgetriebe (417), welches mit der Aufwickelspule ineinander greift und einen zweiten Einweggreifer (417 a) einschließt, und einen Antriebsabschnitt (400) zum Antreiben des Aufwickelgetriebes.

7. Komponenten-Zuführungsvorrichtung nach Anspruch 6, wobei der Antriebsabschnitt (400) durch eine Stützachse (411) drehbar gestützt wird und verbunden ist mit einer Feder (421) zum Betätigen des Antriebsabschnitts, einem Zuführhebel (412), der ein Ende (412 b) aufweist, einem Aufwickelhebel (413), der sich mit dem Zuführhebel gegenseitig verriegelt, und einem Getriebearm (416), der durch den Aufwickelhebel gestützt wird und das Aufwickelgetriebe (417) stützt, wobei der Getriebearm dem Aufwickelgetriebe in Richtung auf die Aufwickelspule (418) Antrieb gibt.

## Revendications

1. Dispositif d'alimentation en pièces, comprenant:
un composant (407) d'alimentation en pièces, dans lequel une bande (408) de transport de pièces, constituée par un organe (407) en forme de bande, présentant des espaces (408b) de réception formés à un pas prédéterminé dans une direction longitudinale de l'organe en forme de bande pour y recevoir des pièces (402), les pièces étant recouvertes par une bande de couverture (409), est avancée par pas prédéterminé, et la bande de couverture est pelée avant une position de délivrance d'une pièce; et
un dispositif (403) d'envidage de bande de recouvrement pour envider la bande de recouvrement pelée, dans lequel
le composant d'alimentation en pièces comprend un obturateur (432) présentant une fente (432c) par laquelle la bande de recouvrement pelée de la bande de transport des pièces passe et est extraite, le dispositif d'alimentation comprenant en outre un dispositif d'envidage de bande de recouvrement comprenant un tambour d'envidage (418) pour envider la bande de recouvrement pelée, et une mâchoire de blocage (453) pour maintenir la bande de recouvrement contre le tambour d'envidage, et présentant un bord (453b) pour couper la fin de la bande de recouvrement.

2. Dispositif d'alimentation en pièces selon la revendication 1, dans lequel la fente (432c) de l'obturateur (432) est pourvue de multiples saillies (432c1) pour recouvrir les espaces (408b) de réception de la bande de transport des pièces.

3. Dispositif d'alimentation en pièces selon la revendication 1, dans lequel le bord (453b) est fait de bavures produites par le traitement de la mâchoire de blocage (453).

4. Dispositif d'alimentation en pièces selon la revendication 1, dans lequel la mâchoire de blocage (453) est attachée à une surface inférieure (454a) d'une rainure (454A, 454B) formée dans une surface du tambour d'envidage (418).

5. Dispositif d'alimentation en pièces selon la revendication 1, dans lequel une rainure d'introduction (454c) pour guider la bande de recouvrement (409) est prévue à la surface inférieure (454a) du tambour d'envidage (418).

6. Dispositif d'alimentation en pièces selon la revendication 1, dans lequel la dispositif d'envidage de la bande de recouvrement comprend un tambour d'envidage (418) pourvu de dents et possédant un axe (428) pourvu d'un premier accouplement à roue libre (418a), un engrenage d'envidage (417) engageant le tambour d'envidage, et comprenant un second accouplement à roue libre (417a), et un composant meneur (400) pour entraîner l'engrenage d'envidage.

7. Dispositif d'alimentation en pièces selon la revendication 6, dans lequel le composant meneur (400) est supporté à rotation par un axe de support (411) et relié à un ressort (421) pour activer le composant meneur, un levier d'alimentation (412) présentant une extrémité (412b), un levier d'envidage (413) qui s'enclenche avec le levier d'alimentation, et un bras d'engrenage (416) supporté par le levier d'envidage et supportant l'engrenage d'envidage (417), le bras d'engrenage servant à activer l'engrenage d'envidage par rapport au tambour d'envidage (418).
